(19) **Europäisches Patentamt / European Patent Office / Office européen des brevets**

(11) **EP 4 465 061 B1**

(12) **EUROPEAN PATENT SPECIFICATION**

(45) Date of publication and mention
of the grant of the patent:
**22.07.2026   Bulletin 2026/30**

(21) Application number: **23860853.3**

(22) Date of filing: **29.08.2023**

(51) International Patent Classification (IPC):
**G01R 31/392** $^{(2019.01)}$   **G01R 31/396** $^{(2019.01)}$
**G01R 31/385** $^{(2019.01)}$   **G01R 19/165** $^{(2006.01)}$
**G01R 19/10** $^{(2006.01)}$   **B60L 58/10** $^{(2019.01)}$
**G01R 31/374** $^{(2019.01)}$   **G01R 31/3835** $^{(2019.01)}$
**B60L 3/00** $^{(2019.01)}$   **B60L 3/12** $^{(2006.01)}$

(52) Cooperative Patent Classification (CPC):
**B60L 3/12; B60L 3/0046; G01R 31/392;**
**G01R 31/396;** B60L 2240/545; B60L 2240/547;
G01R 31/374

(86) International application number:
**PCT/KR2023/012819**

(87) International publication number:
**WO 2024/049177 (07.03.2024 Gazette 2024/10)**

(54) **BATTERY DIAGNOSING APPARATUS, BATTERY PACK, ELECTRIC VEHICLE AND BATTERY DIAGNOSING METHOD**

BATTERIEDIAGNOSEVORRICHTUNG, BATTERIEPACK, ELEKTROFAHRZEUG UND BATTERIEDIAGNOSEVERFAHREN

DISPOSITIF DE DIAGNOSTIC DE BATTERIE, BLOC-BATTERIE, VÉHICULE ÉLECTRIQUE ET PROCÉDÉ DE DIAGNOSTIC DE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **02.09.2022   KR 20220111696**
**08.08.2023   KR 20230103523**

(43) Date of publication of application:
**20.11.2024   Bulletin 2024/47**

(73) Proprietor: **LG Energy Solution, Ltd.**
**Seoul 07335 (KR)**

(72) Inventors:
• **CHOI, Soon-Ju**
**Daejeon 34122 (KR)**
• **KIM, Dae-Soo**
**Daejeon 34122 (KR)**
• **KIM, Young-Deok**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
EP-A1- 3 930 075          JP-A- 2022 519 073
KR-A- 20060 089 842    KR-A- 20130 116 170
KR-A- 20180 092 863    KR-A- 20200 018 084
US-A1- 2018 233 786    US-A1- 2022 276 314

## Description

TECHNICAL FIELD

The present disclosure relates to battery diagnosis, and more specifically, to a technology for diagnosing abnormality of a plurality of batteries connected in series.

US 2022/0276314 A1 discloses a battery management apparatus and a method. The battery management apparatus is configured to diagnose a state of a battery cell based on a capacity-voltage differential profile. Specifically, the battery management apparatus diagnoses a state of the battery cell according to a change pattern of a peak associated with a positive electrode reaction area and a peak associated with an available lithium loss in the capacity-voltage differential profile. The state of the battery cell may be diagnosed in real time even while the battery cell is in operation. In addition, it is possible to independently diagnose whether the positive electrode reaction area of the battery cell is reduced and whether available lithium is lost.

SUMMARY

The present invention is defined by the independent claims. Advantageous embodiments are described by the dependent claims.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being done on these batteries in terms of increasing capacity and density, but improving lifespan and safety is also important. To achieve this, it is necessary to suppress the decomposition reaction with the electrolyte on the electrode surface and prevent overcharge and overdischarge.

In particular, during charging or discharging of a battery array containing a plurality of batteries connected in series, the same current flows through all batteries, so it is difficult to diagnose the status of individual batteries. Therefore, there is a need to develop technology to diagnose abnormalities in individual batteries by analyzing the voltage behavior of each of the plurality of batteries during charging or discharging.

DISCLOSURE

Technical Problem

The present disclosure is designed to solve the problems of the related art, and therefore the present disclosure is directed to providing a battery diagnosing apparatus and a battery diagnosing method that can quickly and accurately detect abnormalities of individual batteries through relative comparison between a plurality of voltage profiles obtained for the plurality of batteries.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

A battery diagnosing apparatus according to one aspect of the present disclosure is provided for a battery array including first to $m^{th}$ batteries connected in series, wherein m is a natural number of 3 or more. The battery diagnosing apparatus comprises a measuring unit configured to detect voltage of each of the first to $m^{th}$ batteries; and a control unit configured to generate first to $m^{th}$ voltage profiles representing a voltage change history of each of the first to $m^{th}$ batteries, based on voltage measurement data collected from the measuring unit during charging or discharging of the battery array. The control unit is configured to diagnose the battery array by comparing each of the first to $(m-1)^{th}$ comparison voltage profiles with a criterion voltage profile. The criterion voltage profile is one of the first to $m^{th}$ voltage profiles, and the first to $(m-1)^{th}$ comparison voltage profiles are remaining (m-1) voltage profiles other than the criterion voltage profile.

The control unit may be configured to generate first to $(m-1)^{th}$ adjusted comparison voltage profiles by adjusting the first to $(m-1)^{th}$ comparison voltage profiles respectively, so that an error amount of each of the first to (m-1)th adjusted comparison voltage profiles with the criterion voltage profile is minimized. The control unit may be configured to generate first to $(m-1)^{th}$ main adjustment information representing adjustment levels from the first to $(m-1)^{th}$ comparison voltage profiles to the first to $(m-1)^{th}$ adjusted comparison voltage profiles and diagnose the battery array based on the first to $(m-1)^{th}$ main adjustment information.

The control unit may be configured to determine the sum of squares or the root mean square error of the voltage difference between a $j^{th}$ adjusted comparison voltage profile among the first to $(m-1)^{th}$ adjusted comparison voltage profiles and the criterion voltage profile as the error amount between the $j^{th}$ comparison voltage profile and the criterion voltage profile. j is a natural number less than m.

The control unit may be configured to determine a $j^{th}$ voltage shift factor from the $j^{th}$ comparison voltage profile to the $j^{th}$ adjusted comparison voltage profile. Among the first to $(m-1)^{th}$ main adjustment information, the $j^{th}$ main adjustment information may include the $j^{th}$ voltage shift factor.

The control unit may be configured to diagnose abnormality of each of the first to $m^{th}$ batteries or the battery array based on a distribution of first to $(m-1)^{th}$ voltage shift factors of the first to $(m-1)^{th}$ main adjustment information.

The control unit may be configured to determine a $j^{th}$ voltage scaling factor from the $j^{th}$ comparison voltage profile to the $j^{th}$ adjusted comparison voltage profile. Among the first to $(m-1)^{th}$ main adjustment information, the $j^{th}$ main adjustment information may include the $j^{th}$ voltage scaling factor.

The control unit may be configured to diagnose abnormality of each of the first to $m^{th}$ batteries or the battery array based on a distribution of first to $(m-1)^{th}$ voltage scaling factors of the first to $(m-1)^{th}$ main adjustment information.

The control unit may be configured to generate a criterion differential voltage profile from the criterion voltage profile. The control unit may be configured to generate first to $(m-1)^{th}$ comparison differential voltage profiles from the first to $(m-1)^{th}$ comparison voltage profiles. The control unit may be configured to generate first to $(m-1)^{th}$ adjusted comparison differential voltage profiles by adjusting the first to $(m-1)^{th}$ comparison differential voltage profiles respectively, so that an error amount of each of the first to $(m-1)^{th}$ adjusted comparison differential voltage profiles with the criterion differential voltage profile is minimized. The control unit may be configured to generate first to $(m-1)^{th}$ sub adjustment information representing adjustment levels from the first to $(m-1)^{th}$ comparison differential voltage profiles to the first to $(m-1)^{th}$ adjusted comparison differential voltage profiles, and diagnose abnormality of each of the first to $m^{th}$ batteries or the battery array further based on the first to $(m-1)^{th}$ sub adjustment information.

The control unit may be configured to determine a $j^{th}$ differential voltage shift factor from the $j^{th}$ comparison differential voltage profile to the $j^{th}$ adjusted comparison differential voltage profile. Among the first to $(m-1)^{th}$ sub adjustment information, the $j^{th}$ sub adjustment information may include the $j^{th}$ differential voltage shift factor.

The control unit may be configured to determine a $j^{th}$ differential voltage scaling factor from the $j^{th}$ comparison differential voltage profile to the $j^{th}$ adjusted comparison differential voltage profile. Among the first to $(m-1)^{th}$ sub adjustment information, the $j^{th}$ sub adjustment information may include the $j^{th}$ differential voltage scaling factor.

A battery pack according to another aspect of the present disclosure comprises the battery diagnosing apparatus.

An electric vehicle according to still another aspect of the present disclosure comprises the battery pack.

A battery diagnosing method according to still another aspect of the present disclosure is provided for a battery array including first to $m^{th}$ batteries connected in series, wherein m is a natural number of 3 or more. The battery diagnosing method comprises: collecting voltage measurement data representing voltage of each of the first to $m^{th}$ batteries during charging or discharging of the battery array; generating first to $m^{th}$ voltage profiles representing a voltage change history of each of the first to $m^{th}$ batteries, based on the voltage measurement data; and diagnosing the battery array by comparing each of first to $(m-1)^{th}$ comparison voltage profiles with a criterion voltage profile. The criterion voltage profile is one of the first to $m^{th}$ voltage profiles, and the first to $(m-1)^{th}$ comparison voltage profiles are remaining $(m-1)$ voltage profiles other than the criterion voltage profile.

The step of diagnosing the battery array may include: generating first to $(m-1)^{th}$ adjusted comparison voltage profiles by adjusting the first to $(m-1)^{th}$ comparison voltage profiles respectively, so that an error amount of each of the first to $(m-1)^{th}$ adjusted comparison voltage profiles with the criterion voltage profile is minimized; generating first to $(m-1)^{th}$ main adjustment information representing adjustment levels from the first to $(m-1)^{th}$ comparison voltage profiles to the first to $(m-1)^{th}$ adjusted comparison voltage profiles; and diagnosing abnormality of each of the first to $m^{th}$ batteries or the battery array based on the first to $(m-1)^{th}$ main adjustment information.

The battery diagnosing method may further comprise: generating a criterion differential voltage profile from the criterion voltage profile; generating first to $(m-1)^{th}$ comparison differential voltage profiles from the first to $(m-1)^{th}$ comparison voltage profiles; generating first to $(m-1)^{th}$ adjusted comparison differential voltage profiles by adjusting the first to $(m-1)^{th}$ comparison differential voltage profiles respectively, so that an error amount of each of the first to $(m-1)th$ adjusted comparison differential voltage profiles with the criterion differential voltage profile is minimized; and generating first to $(m-1)^{th}$ sub adjustment information representing adjustment levels from the first to $(m-1)^{th}$ comparison differential voltage profiles to the first to $(m-1)^{th}$ adjusted comparison differential voltage profiles.

The step of diagnosing the battery array may diagnose the battery array further based on the first to $(m-1)^{th}$ sub adjustment information.

<u>Advantageous Effects</u>

According to at least one of the embodiments of the present disclosure, by analyzing the adjustment information of the adjustment process of adjusting each remaining voltage profile so that the error amount with any one voltage profile among the plurality of voltage profiles related one to one to the plurality of batteries connected in series is minimized, it is possible to detect abnormalities of each battery. In other words, since abnormalities can be detected by analyzing the voltage change history of each of the plurality of batteries, the speed of abnormality detection is improved compared to other diagnostic methods that require additional parameters such as battery temperature.

In addition, according to at least one of the embodiments of the present disclosure, since abnormalities of individual batteries are diagnosed by calculating the error amount with each of the remaining voltage profiles based on one voltage profile among the plurality of voltage profiles, abnormalities can be detected even though reference data is not secured in advance, and there is an advantage that a high-capacity memory is not necessarily required.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing a battery diagnosing apparatus according to an embodiment of the present disclosure.
FIG. 2 is a diagram schematically showing the coupling relationship between the batteries and the measuring unit shown in FIG. 1.
FIGS. 3 to 7 are graphs referenced to explain adjustment operations executable to generate an adjusted comparison voltage profile from the comparison voltage profile.
FIG. 8 is a diagram referenced to explain the process of calculating the error amount between the criterion voltage profile and the adjusted comparison voltage profile.
FIG. 9 is a diagram referenced to explain the differential voltage profile generated from the voltage profile.
FIG. 10 is a diagram referenced to explain the differential capacity profile generated from the voltage profile.
FIG. 11 is a diagram showing an example of the distribution of voltage scaling factors related to a specific adjustment operation of the adjustment process.
FIG. 12 is a diagram showing another example of the distribution of voltage scaling factors related to a specific adjustment operation of the adjustment process.
FIG. 13 is a diagram showing still another example of the distribution of voltage scaling factors related to a specific adjustment operation of the adjustment process.
FIG. 14 is a diagram showing still another example of the distribution of voltage scaling factors related to a specific adjustment operation of the adjustment process.
FIG. 15 is a diagram exemplarily showing a battery pack according to the present disclosure.
FIG. 16 is a diagram exemplarily showing an electric vehicle including the battery pack shown in FIG. 15.
FIG. 17 is a flowchart schematically showing the battery diagnosing method according to an embodiment of the present disclosure.
FIG. 18 is a flowchart exemplarily showing subroutines that can be included in step S1740 of FIG. 17.
FIG. 19 is a flowchart showing an example of subroutines that can be added to step S1740 of FIG. 17.
FIG. 20 is a flowchart showing another example of subroutines that can be added to step S1740 of FIG. 17.

BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise. Additionally, terms such as "... unit" described in the specification refer to a unit that processes at least one function or operation, and may be implemented as hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

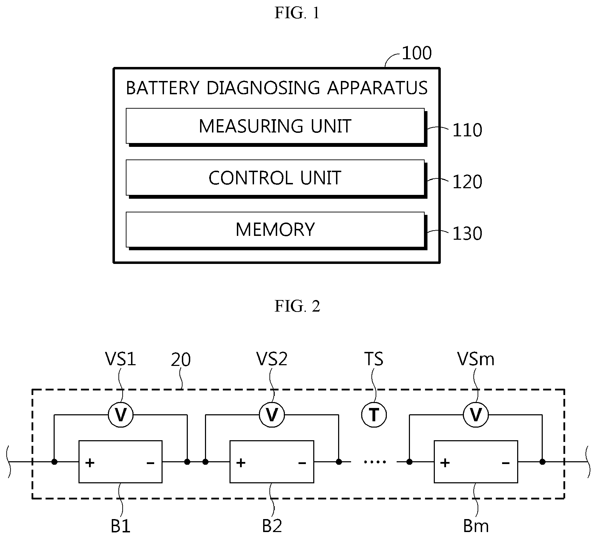

FIG. 1 is a diagram schematically showing a battery diagnosing apparatus according to an embodiment of the present disclosure, and FIG. 2 is a diagram schematically showing the coupling relationship between the batteries and the measuring unit shown in FIG. 1.

Referring to FIGS. 1 and 2, the battery diagnosing apparatus 100 includes a measuring unit 110 and a control unit 120, and may optionally further include a memory 130.

The battery diagnosing apparatus 100 is provided to detect abnormalities of the battery array 20 or each of first to $m^{th}$ batteries B1 to Bm included therein. m is a natural number of 3 or more.

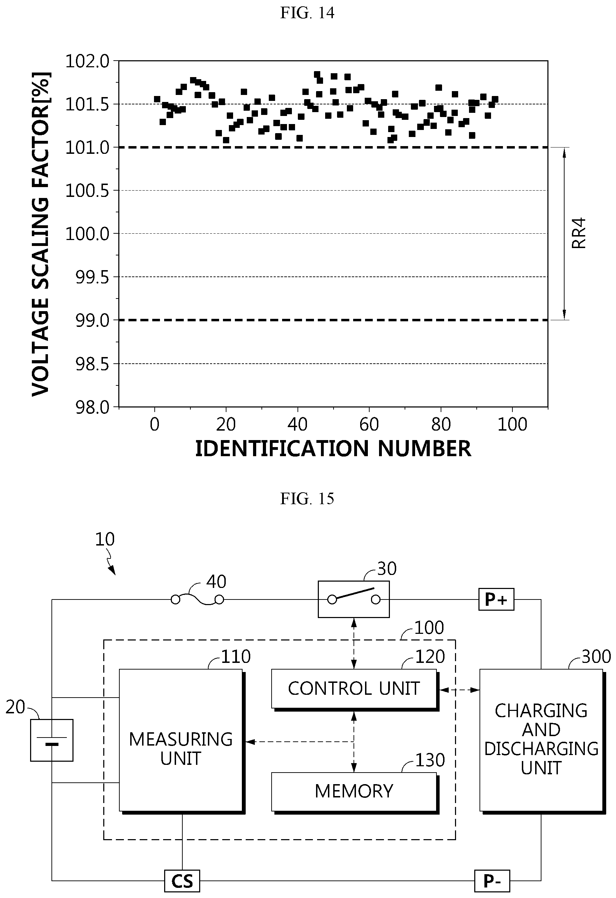

The first to $m^{th}$ batteries B1 to Bm are electrically connected in series within the battery array 20. The battery array 20 may be included in a battery pack (symbol 10 in FIG. 15). In the following, in the common explanation of the first to $m^{th}$ batteries B1 to Bm, B will be used as a symbol representing a battery (cell group).

The battery B may include at least one battery cell. The battery cell refers to an energy storage element that has a negative electrode terminal and a positive electrode terminal and is capable of repeated charging and discharging independently. For example, battery cells include lithium-ion cells or lithium polymer cells. If the battery B includes a plurality of battery cells, the battery B may be referred to as a 'cell group'. Among the plurality of battery cells in the cell group B, at least two battery cells may be connected in parallel.

The measuring unit 110 may be configured to measure the voltage of each of the first to $m^{th}$ batteries B1 to Bm. Voltage measurement by the measuring unit 110 may be performed periodically according to a predetermined sampling rate (e.g., 60 times/sec). The measuring unit 110 may provide the control unit 120 with voltage measurement data including the measured value of voltage of each of the first to $m^{th}$ batteries B1 to Bm.

The measuring unit 110 may include first to $m^{th}$ voltage sensors. Assuming that i is a natural number less than or equal to m, the $i^{th}$ voltage sensor may generate a sensing signal representing the voltage value of the voltage across both ends of the $i^{th}$ battery Bi. The control unit 120 may collect the sensing signal (voltage measurement data) from the $i^{th}$ voltage sensor and monitor the voltage of the $i^{th}$ battery Bi in real time.

The measuring unit 110 may include a current sensor (symbol CS in FIG. 15). The current sensor CS may include a known current detection element, such as, for example, a shunt resistor and/or a Hall sensor. The current sensor CS may generate a sensing signal (current measurement data) that represents the current value (i.e., the size and direction of the current) of the current flowing through the battery array 20. The control unit 120 is capable of periodically collecting current measurement data from the current sensor CS and calculating the cumulative capacity (current integration value) from a specific time based on this.

The measuring unit 110 may include at least one temperature sensor TS. When there is one temperature sensor TS included in the measuring unit 110, the temperature measured by the temperature sensor TS may be treated as a representative temperature (e.g., average temperature) of the first to $m^{th}$ batteries B1 to Bm.

Alternatively, the measuring unit 110 may include m temperature sensors TS, and in this case, the m temperature sensors TS may be configured to measure the temperature of each of the first to $m^{th}$ batteries B1 to Bm. The control unit 120 may collect the sensing signal from each of the m temperature sensors TS and monitor the temperature of each of the first to $m^{th}$ batteries B1 to Bm in real time.

As the temperature sensor TS, a temperature detection means known in the art, such as a thermocouple, can be used.

Referring to FIG. 2, the first to $m^{th}$ voltage sensors VS1 to VSm are connected in parallel to the first to $m^{th}$ batteries B1 to Bm in one-to-one. That is, the pair of measurement terminals of the $i^{th}$ voltage sensor (VSi) are connected to the positive electrode terminal and the negative electrode terminal of the $i^{th}$ battery Bi, respectively.

Specifically, the first voltage sensor VS1 may be configured to measure the voltage across both ends of the first battery B1 while the first battery B1 is being charged or discharged. The second measuring unit VS2 may be configured to measure the voltage across both ends of the second battery B2 while the second battery B2 is being charged or discharged. The $m^{th}$ measuring unit VSm may be configured to measure the voltage while the $m^{th}$ battery (Bm) is being charged or discharged.

Here, since the first to $m^{th}$ batteries B1 to Bm are electrically connected to each other in series, while the first to $m^{th}$ batteries B1 to Bm are charging or discharging, the same charging current or discharging current flows through the first to $m^{th}$ batteries B1 to Bm. For example, under the control of the control unit 120, the first to $m^{th}$ batteries B1 to Bm may be charged or discharged with a constant current at a predetermined current rate.

The control unit 120 may generate first to $m^{th}$ voltage profiles representing the voltage change history of each of the first to $m^{th}$ batteries B1 to Bm while the battery pack 10 is being charged or discharged. Each voltage profile is a type of voltage time series that represents the change in voltage according to time or capacity, and may be called a relationship curve between time and voltage or a relationship curve between capacity and voltage. Hereinafter, for convenience of explanation, it will be assumed that each voltage profile represents the change in voltage according to capacity.

As described above, during charging or discharging of the battery pack 10, the same current flows through the first to $m^{th}$ batteries B1 to Bm. Accordingly, the control unit 120 may monitor capacity changes during charging or discharging of the battery pack 10 through ampere counting that periodically integrates the current value collected from the current sensor CS.

The control unit 120 may generate an $i^{th}$ voltage profile based on the capacity and voltage of the $i^{th}$ battery Bi while the first to $m^{th}$ batteries B1 to Bm are charged or discharged with constant current or non-constant current. That is, the control unit 120 may generate an $i^{th}$ voltage profile by repeating the operation of mapping the monitored capacity (or measurement time) and voltage to each other at each timing for the $i^{th}$ battery Bi and recording them in the memory. Accordingly, the first to $m^{th}$ voltage profiles that are one-to-one related to the first to $m^{th}$ batteries B1 to Bm are generated. Below, the battery diagnosis process using the voltage profile will be described in more detail.

The memory 130 may store data required for each component of the battery diagnosing apparatus 100 to perform operations and functions. Also, the memory 130 may store data collected or generated in the process of performing programs or operations and functions of each of the measuring unit 110 and the control unit 120. The memory 130 may be internal or external to the control unit 120, and may be operably coupled to the control unit 120 by various well-known means such as data bus. The memory 130 may store at least one program, application, data, or instructions executed by the control unit 120.

The type of memory 130 is not particularly limited as long as it is known information storage means capable of recording, erasing, updating, and reading data. As an example, the memory 130 may be implemented as at least one of a flash memory type, a hard disk type, a solid state disk (SSD) type, a solid disk drive (SDD) type, a multimedia card micro type, a random access memory (RAM), and a static RAM (SRAM), a ROM (Read Only Memory), an EEPROM (Electrically Erasable Programmable Read Only Memory), and a PROM (Programmable Read Only Memory), but the present disclosure is not necessarily limited to the specific form of the memory. Also, the memory 130 may store program codes in which processes executable by the control unit 120 are defined.

In the memory 130, battery identification numbers pre-assigned for the first to $m^{th}$ batteries B1 to Bm may be recorded. The control unit 120 may map the identification number of the $i^{th}$ battery Bi to the data associated with the $i^{th}$ battery Bi and record it in the memory 130 during the implementation of the diagnosis process according to the present disclosure.

The control unit 120 may be configured to set one of the first to $m^{th}$ voltage profiles as the criterion voltage profile and set the remaining (m-1) voltage profiles as the first to $(m-1)^{th}$ comparison voltage profiles.

The criterion voltage profile may be randomly selected from the first to $m^{th}$ voltage profiles. Alternatively, the control unit 120 may select as the criterion voltage profile the voltage profile associated with a battery whose voltage or SOC is closest to the average of the first to $m^{th}$ batteries among the first to $m^{th}$ batteries.

The criterion voltage profile may be a voltage profile set as a standard for relative comparison of the full charge capacity (FCC) of the first to $m^{th}$ batteries B1 to Bm. In addition, the control unit 120 may select the remaining (m-1) voltage profiles, excluding the criterion voltage profile, among the first to $m^{th}$ voltage profiles as the first to $(m-1)^{th}$ comparison voltage profile, which is the subject of an adjustment operation to be described later.

For example, if the voltage profile of the first battery B1 is selected as the criterion voltage profile, the control unit 120 may set the second to $m^{th}$ voltage profiles of the second to $m^{th}$ batteries B2 to Bm as the first to $(m-1)^{th}$ comparison voltage profiles. In the above example, those skilled in the art will easily understand that the second voltage profile will be set as the first comparison voltage profile, and the $m^{th}$ voltage profile will be set as the $(m-1)^{th}$ comparison voltage profile.

The control unit 120 diagnoses abnormality of the battery array 20 or the battery B by comparing the first to $(m-1)^{th}$ comparison voltage profiles with the criterion voltage profile.

In detail, the control unit 120 may generate first to $(m-1)^{th}$ adjusted comparison voltage profiles by adjusting each of the first to $(m-1)^{th}$ comparison voltage profiles to correspond to the criterion voltage profile. Corresponding to the criterion voltage profile means that the error amount with the criterion voltage profile is minimal or within a predetermined tolerance range. Here, when j is a natural number less than m, the error amount between the criterion voltage profile and the $j^{th}$ adjusted comparison voltage profile may be the sum of squares of the voltage difference between the $j^{th}$ adjusted comparison voltage profile and the criterion voltage profile, or the root mean square error (RMSE) thereof, or the integral value thereof, or the integral value of the absolute value of the voltage difference over the specific capacity range.

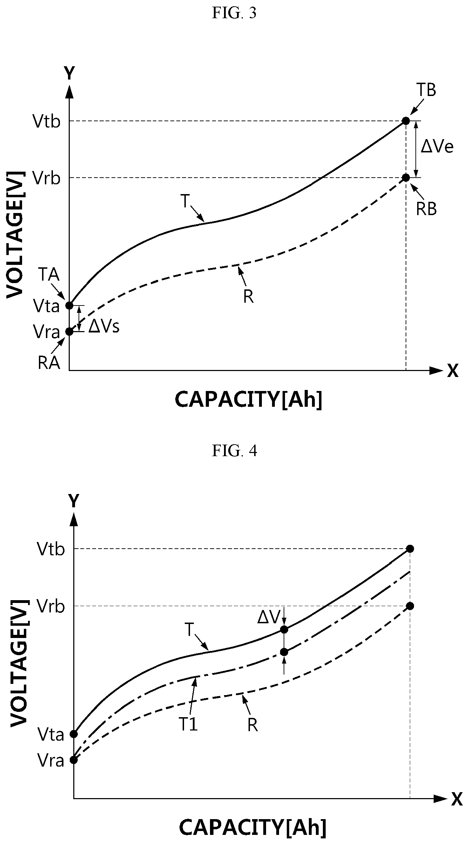

The $j^{th}$ adjusted comparison voltage profile is one of the plurality of adjusted comparison voltage profiles obtained by adjusting the $j^{th}$ comparison voltage profile to various levels. The control unit 120 may calculate the root mean square error (RMSE) between each of the plurality of adjusted comparison voltage profiles obtained from the $j^{th}$ comparison voltage profile and the criterion voltage profile, and specify any one of the plurality of adjusted comparison voltage profiles, which RMSE is minimal, as the $j^{th}$ adjusted comparison voltage profile. The adjustment operations that the control unit 120 performs for each comparison voltage profile to correspond to the criterion voltage profile will be described in more detail later with reference to FIGS. 3 to 7.

The control unit 120 may generate first to $(m-1)^{th}$ main adjustment information representing the adjustment level from the first to $(m-1)^{th}$ comparison voltage profile to the first to $(m-1)^{th}$ adjusted comparison voltage profile. The $j^{th}$ main adjustment information may be a data set that defines how and to what extent the $j^{th}$ comparison voltage profile is adjusted to generate the $j^{th}$ adjusted comparison voltage profile.

The adjustment process from the first to $(m-1)^{th}$ comparison voltage profile to the first to $(m-1)^{th}$ adjusted comparison voltage profile essentially includes a first adjustment operation (Y-axis shift), and may optionally further include at least one of a second adjustment operation (Y-axis scaling), a third adjustment operation (X-axis shift), and a fourth adjustment operation (X-axis scaling).

The first adjustment operation (Y-axis shift) may be an operation that moves the $j^{th}$ comparison voltage profile overall along the Y-axis (voltage). The adjustment amount by the first adjustment operation may be referred to as voltage shift amount (or voltage shift factor). For example, the voltage shift factor of +0.1 V means that the $j^{th}$ adjusted comparison voltage profile is located 0.1 V higher (higher voltage) than the $j^{th}$ comparison voltage profile as a whole.

The second adjustment operation (Y-axis scaling) may be an operation to shrink or expand the $j^{th}$ comparison voltage profile along the Y-axis. The adjustment amount by the second adjustment operation may be referred to as voltage scaling amount (or voltage scaling factor). For example, a voltage scaling factor of 101% means that the voltage range of the $j^{th}$ adjusted comparison voltage profile is 1.01 times the voltage range of the $j^{th}$ comparison voltage profile, and a voltage shift factor of 98% means that the voltage range of the $j^{th}$ adjusted comparison voltage profile is 0.98 times the voltage range of the $j^{th}$ comparison voltage profile.

The third adjustment operation (X-axis shift) may be an operation that moves the $j^{th}$ comparison voltage profile overall along the X-axis (capacity). The adjustment amount by the third adjustment operation may be referred to as capacity shift amount (or capacity shift factor). For example, the capacity shift factor of -2.2 Ah means that the $j^{th}$ adjusted comparison voltage profile is located to the left (lower capacity) by 2.2 Ah as a whole compared to the $j^{th}$ comparison voltage profile.

The fourth adjustment operation (X-axis scaling) may be an operation to shrink or expand the $j^{th}$ comparison voltage profile along the X-axis. The adjustment amount by the fourth adjustment operation may be referred to as capacity scaling amount (or capacity scaling factor). For example, a capacity scaling factor of 103% means that the capacity range of the $j^{th}$ adjusted comparison voltage profile is 1.03 times the capacity range of the $j^{th}$ comparison voltage profile.

The $j^{th}$ main adjustment information may include an adjustment amount according to the first adjustment operation and may further include at least one of adjustment amounts according to the second to fourth adjustment operations. Additionally, since the adjustment operation for the criterion voltage profile is not executed, the adjustment amounts of the first to fourth adjustment operations related to the criterion voltage profile may be defaulted to 0 V, 100%, 0 Ah, and 100%, respectively. For reference, that is, units other than V, Ah, and % may be used as units of adjustment amounts.

The control unit 120 may be configured to identify abnormality of each of the first to $m^{th}$ batteries B1 to Bm or abnormality of the battery array 20, based on the first to $(m-1)^{th}$ main adjustment information.

When the X-axis length (i.e., capacity range) of the $j^{th}$ adjusted comparison voltage profile is relatively longer than the X-axis length of the $j^{th}$ comparison voltage profile (for example, enlargement, the capacity scaling factor exceeds 100%), the control unit 120 may identify that the full charge capacity of the battery related to the $j^{th}$ comparison voltage profile is smaller than the full charge capacity of the criterion battery by the amount corresponding to the adjustment information.

When the X-axis length (i.e., capacity range) of the $j^{th}$ adjusted comparison voltage profile is relatively shorter than the X-axis length of the $j^{th}$ comparison voltage profile (for example, shrinkage, the capacity scaling factor is less than 100%), the control unit 120 may identify that the full charge capacity of the battery related to the $j^{th}$ comparison voltage profile is larger than the full charge capacity of the criterion battery by the amount corresponding to the adjustment information.

For example, when the full charge capacity of the criterion battery is 100 Ah, if the $j^{th}$ main adjustment information is 103%, the control unit 120 may determine that the full charge capacity of the battery related to the $j^{th}$ comparison voltage profile is smaller than the full charge capacity of the criterion battery by 3%p.

The control unit 120 may diagnose abnormality of each of the first to $m^{th}$ batteries B1 to Bm or abnormality of the battery array 20 by analyzing the distribution of adjustment amounts of the same type in the first to $(m-1)^{th}$ main adjustment information. That is, the control unit 120 may determine abnormality of each of the first to $m^{th}$ batteries B1 to Bm based on at least one of the distribution of adjustment amounts by the first adjustment operation, the distribution of adjustment amounts by the second adjustment operation, the distribution of adjustment amounts by the third adjustment operation, and the distribution of adjustment amounts by the fourth adjustment operation.

The control unit 120 may be configured to determine that, among the first to $m^{th}$ batteries B1 to Bm, the battery associated with the adjustment amount that falls within the criterion range for each adjustment operation is normal, and the other batteries are abnormal.

If all adjustment amounts of the first to $m^{th}$ batteries B1 to Bm are within the criterion range, the control unit 120 may determine that all first to $m^{th}$ batteries B1 to Bm are normal.

The control unit 120 may determine that the battery array 20 is normal if the number of adjustment amounts beyond the criterion range among the adjustment amounts of the first to $m^{th}$ batteries B1 to Bm is less than a threshold value, and, otherwise, determine that the battery array 20 is abnormal.

When the battery B is normal, it means that the voltage characteristics and capacity characteristics of the battery B have a difference of an acceptable level compared to other batteries in the battery array 20.

The battery diagnosing apparatus 100 may easily check the state of each of the first to $m^{th}$ batteries B1 to Bm using the first to $(m-1)^{th}$ main adjustment information.

Even when the first to $m^{th}$ batteries B1 to Bm connected in series are charged or discharged by current of the same direction and size, the actual capacity change amount of each battery may be different from the capacity change amount (current integration value) by ampere counting due to the electrochemical characteristics of each battery or the impedance of the charger and discharger, etc.

The battery diagnosing apparatus 100 may identify the relative abnormality level of each of the first to $m^{th}$ batteries B1 to Bm compared to the remaining batteries based on the first to $(m-1)^{th}$ main adjustment information generated as a result of adjusting the first to $(m-1)^{th}$ comparison voltage profile based on the criterion voltage profile. Therefore, the battery diagnosing apparatus 100 according to an embodiment may easily diagnose the state of the battery B without previously recording reference data according to temperature, etc. in the memory 130, so it has the advantage of not requiring a storage space for large capacity in the memory 130.

As described above, the battery diagnosing apparatus 100 has an advantage of improving the speed of abnormality diagnosis by diagnosing battery abnormality using only a single parameter, that is voltage behavior, regardless of the temperature of the battery B.

The control unit 120 is operatively coupled to other components of the battery diagnosing apparatus 100 and may control various operations of the battery diagnosing apparatus 100. The control unit 120 may perform various operations of the battery diagnosing apparatus 100 by executing one or more instructions stored in the memory 130.

The control unit 120 may be referred to as a 'control circuit' or a 'battery controller', and in terms of hardware, it may be implemented using at least one of ASICs (application specific integrated circuits), DSPs (digital signal processors), DSPDs (digital signal processing devices), PLDs (programmable logic devices), FPGAs (field programmable gate arrays), microprocessors, and other electrical units to perform functions. Also, when the control logic is implemented as software, the control unit 120 may be implemented as a set of program modules. At this time, the program module may be stored in the memory 130 and executed by the control unit 120.

In particular, when the battery diagnosing apparatus 100 according to the present disclosure is included in a battery pack 10, the battery pack 10 may include a control device referred to by terms such as MCU (micro controller unit) or BMS (battery management system). At this time, the control unit 120 may be implemented by components such as an MCU or BMS provided in the battery pack 10. Additionally, in this specification, the terms 'to ...' or 'configured to ...' regarding the operation or function of the control unit 120 may include the meaning of 'programmed to ...'.

FIGS. 3 to 7 are graphs referenced to explain adjustment operations executable to generate an adjusted comparison voltage profile from the comparison voltage profile. In each of the graphs shown in FIGS. 3 to 7, the X-axis represents capacity (Ah) and the Y-axis represents voltage (V).

Referring to FIG. 3, the criterion voltage profile R and the comparison voltage profile T are shown. The comparison voltage profile T is any one of the first to $(m-1)^{th}$ comparison voltage profiles. For example, the criterion voltage profile R may be the voltage profile of the second battery B2, and the comparison voltage profile T may be the voltage profile of the first battery B1. For convenience of explanation, each voltage profile is illustrated as representing the relationship between capacity and voltage of the battery when the battery array 20 is charged. It should be noted that X-axis represents the current integration value from a specific time point (e.g., the time of occurrence of a diagnosis-requiring event) rather than the remaining capacity of the battery.

Since the two batteries (e.g., B1, B2) are connected in series, the capacity ranges of the criterion voltage profile R and the comparison voltage profile T (illustrated as 0 to 100 Ah in FIG. 3) are the same.

Referring to FIG. 3, it can be seen that the voltage (Vra) of the start point (RA) of the criterion voltage profile R and the voltage (Vta) of the start point TA of the comparison voltage profile T are different from each other. Additionally, the voltage (Vrb) of the end point RB of the criterion voltage profile R and the voltage (Vtb) of the end point TB of the comparison voltage profile T are also different from each other. The difference between the two voltage profiles R, T is due to the difference in characteristics such as deterioration (full charge capacity) and internal resistance of the two batteries (e.g., B1, B2).

In particular, FIG. 3 illustrates a case where the voltage increase rate of the comparison voltage profile T is greater than the voltage increase rate of the criterion voltage profile R in the same capacity range (0 to 100 Ah), and this can also be seen from the fact that the voltage difference ($\Delta Ve = Vtb - Vrb$) at the end point of the capacity range at 100 Ah is larger than the voltage difference ($\Delta Vs = Vta - Vra$) at the start point 0 Ah of the capacity range. For reference, if the criterion voltage profile R is for the battery B2 and the comparison voltage profile T is for the battery B1, it can be seen from the comparison of the two voltage profiles R, T that the battery B1 has higher internal resistance or lower full charge capacity than the battery B2. In other words, the battery B1 has a higher probability of abnormality than the battery B2.

FIG. 4 is a diagram referenced to exemplarily explain the first adjustment operation for the comparison voltage profile T shown in FIG. 3.

Since the comparison voltage profile T is located above the criterion voltage profile R throughout the capacity range, the error amount between the comparison voltage profile T and the criterion voltage profile R will be reduced if the comparison voltage profile T is shifted downward toward the criterion voltage profile R.

The control unit 120 may perform a first adjustment operation to shift the comparison voltage profile T in the Y-axis direction while fixing the criterion voltage profile R. Referring to FIG. 4, the adjusted comparison voltage profile T1 is the result of moving the comparison voltage profile T by $\Delta V$ in the Y-axis direction.

The control unit 120 may determine the adjustment amount (i.e. voltage shift factor) of the first adjustment operation in which the error amount is minimized by repeating the first adjustment operation of shifting the comparison voltage profile T in the Y-axis direction by a small amount (e.g., 0.001 V) and then monitoring the error amount with the criterion voltage profile R.

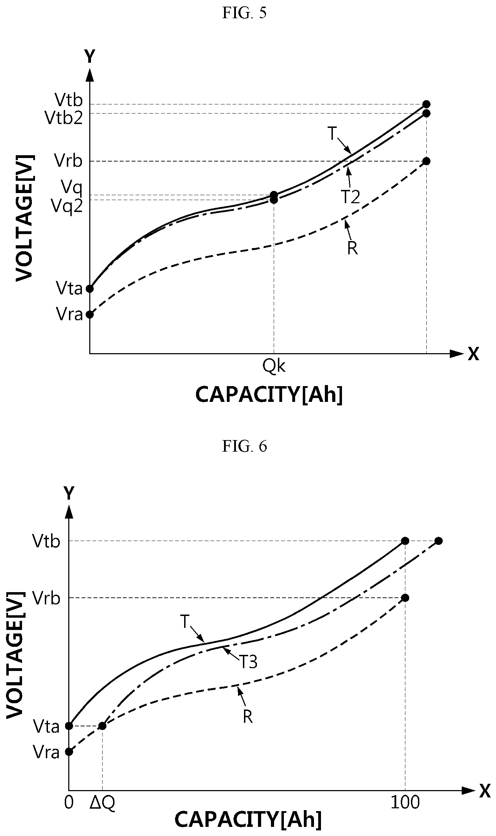

FIG. 5 is a diagram referenced to exemplarily explain the second adjustment operation for the comparison voltage profile T shown in FIG. 3.

The control unit 120 may perform a second adjustment operation to scale (contract or expand) the comparison voltage profile T in the Y-axis direction.

Since the voltage range (Vta to Vtb) of the comparison voltage profile T is larger than the voltage range (Vra to Vrb) of the criterion voltage profile R, the error amount between the comparison voltage profile T and the criterion voltage profile R will be reduced if the comparison voltage profile T is shrunk (compressed) in the Y-axis direction.

The control unit 120 may determine the adjustment amount (i.e. voltage scaling factor) of the second adjustment operation in which the error amount is minimized by repeating the second adjustment operation of shrinking the comparison voltage profile T by a small percentage (e.g., 0.01%) along the Y-axis and then monitoring the error amount with the criterion voltage profile R.

In FIG. 5, the adjusted comparison voltage profile T2 is the result of scaling the comparison voltage profile T so that the start point TA of the comparison voltage profile T is fixed and the remaining portion is shrunk along the Y-axis. For example, the voltage scaling factor of 99% means that the size of the voltage range (Vtb2 - Vta) of the adjusted comparison voltage profile T2 is 99% of the size of the voltage range (Vtb - Vta) of the comparison voltage profile T. In addition, when the voltage of the comparison voltage profile T in the specific capacity (Qk) is Vq and the voltage of the adjusted comparison voltage profile T2 is Vq2, Vq2 = Vta + (Vq - Vta) * 0.99 [V].

FIG. 6 is a diagram referenced to exemplarily explain the third adjustment operation for the comparison voltage profile T shown in FIG. 3.

In FIG. 3 as seen above, as the capacity along the X-axis increases, the voltage difference between the criterion voltage profile R and the comparison voltage profile T tends to increase, so the error amount between the comparison voltage profile T and the criterion voltage profile R will be reduced if the comparison voltage profile T is shifted to the right along the X-axis.

The control unit 120 may perform a third adjustment operation to shift the comparison voltage profile T in the X-axis direction. Referring to FIG. 6, the adjusted comparison voltage profile T3 is the result of moving the comparison voltage profile T by $\Delta Q$ in the Y-axis direction. The voltage of the start point and the voltage of the end point of the adjusted comparison voltage profile T3 are the same as the comparison voltage profile T.

The control unit 120 may determine the adjustment amount (i.e. capacity shift factor) of the third adjustment operation in which the error amount is minimized by repeating the third adjustment operation of shifting the comparison voltage profile T by a small amount (e.g., 0.01 Ah) in the X-axis direction and then monitoring the error amount with the criterion voltage profile R.

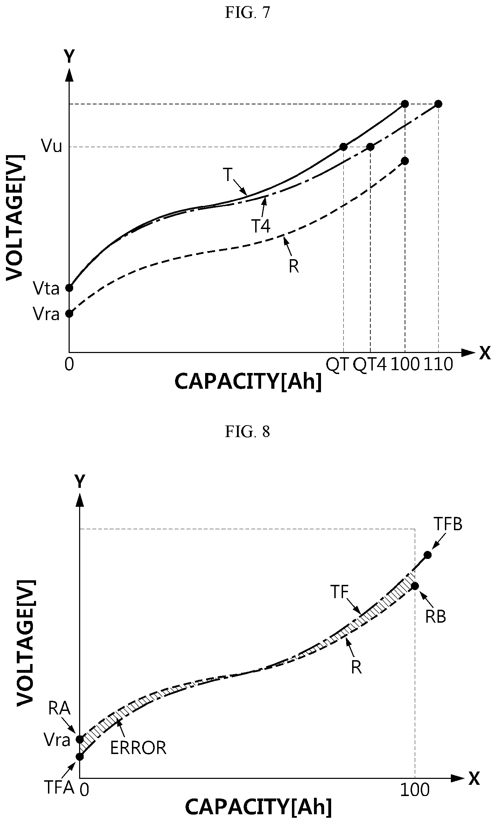

FIG. 7 is a diagram referenced to exemplarily explain the fourth adjustment operation for the comparison voltage profile T shown in FIG. 3.

The control unit 120 may perform a fourth adjustment operation to scale (contract or expand) the comparison voltage profile T in the X-axis direction.

Since the voltage slope of the comparison voltage profile T is steeper than the voltage slope of the criterion voltage profile R, the error amount between the comparison voltage profile T and the criterion voltage profile R will be reduced if the comparison voltage profile T is expanded in the X-axis direction.

The control unit 120 may determine the adjustment amount (i.e. capacity scaling factor) of the fourth adjustment operation in which the error amount is minimized by repeating the fourth adjustment operation of expanding the comparison voltage profile T by a small percentage (e.g., 0.01%) along the X-axis and then monitoring the error amount with the criterion voltage profile R.

For example, a capacity scaling factor of 110% means that the size of the capacity range of the adjusted comparison voltage profile T4 is 1.1 times the capacity range of the comparison voltage profile T. In FIG. 7, the adjusted comparison voltage profile T4 is the result of scaling the comparison voltage profile T so that the start point TA of the comparison voltage profile T is fixed and the remaining part is enlarged by 1.1 times along the X-axis. In addition, when the capacity of the comparison voltage profile T at the specific voltage (Vu) is $Q_T$ and the capacity of the adjusted comparison voltage profile T2 is $Q_{T4}$, $Q_{T4} = 1.1 * Q_T$ [Ah].

When determining the adjustment amount of the fourth adjustment operation, the control unit 120 may be based on the error amount for the portion where the capacity range of the criterion voltage profile R and the capacity range of the adjusted comparison voltage profile T4 overlap with each other. For example, in FIG. 7, the capacity range of the criterion voltage profile R is 0 to 100 Ah, while the capacity range of the adjusted comparison voltage profile T4 is 0 to 110 Ah, so the adjustment amount of the fourth adjustment operation is determined based on the error amount in 0 to 100 Ah, which is the overlapping part of these two ranges.

So far, with reference to FIGS. 3 to 7, the procedure for generating a corresponding adjusted comparison voltage profile from the comparison voltage profile by individually executing the first to fourth adjustment operations has been described.

Relatedly, for the $j^{th}$ comparison voltage profile, only the first adjustment operation may be executed, or at least one of the second to third adjustment operations may be further executed. When generating a $j^{th}$ adjusted comparison voltage profile from the $j^{th}$ comparison voltage profile, the execution order of two or more of the first to fourth adjustment operations may be irrelevant. For example, when combining the first adjustment operation and the second adjustment operation, the second adjustment operation may be performed after the first adjustment operation, or the order may be reversed.

FIG. 8 is a diagram referenced to explain the process of calculating the error amount between the criterion voltage profile and the adjusted comparison voltage profile.

In FIG. 8, the profile TF illustrates an adjusted comparison voltage profile that is specified to have a minimum error amount with the criterion voltage profile R through the above-described adjustment process.

Referring to FIG. 8 along with FIG. 3, the comparison voltage profile T and the adjusted comparison voltage profile TF are compared as follows.

First, the start point TFA of the profile TF is located lower than the start point TA of the profile T, which indicates that the adjustment amount (voltage shift factor) of the first adjustment operation is a negative value.

Second, if the voltage difference between the start point TFA and the end point TFB of the profile TF is smaller than the voltage difference between the start point TA and the end point TB of the profile T, it indicates that the adjustment amount (voltage scaling factor) of the second adjustment operation is less than 100%.

Third, the capacity of the start point TFA of the profile TF and the capacity of the start point TA of the profile T are equal to 0 Ah, which indicates that the adjustment amount (capacity shift factor) of the third adjustment operation is 0.

Fourth, the capacity range of the profile TF is wider than the capacity range of the profile T, which indicates that the adjustment amount (capacity scaling factor) of the fourth adjustment operation is more than or equal to 100%.

The control unit 120 may set 0 to 100 Ah, which is common in the profile TF and the profile R, as the capacity range of interest. Next, the control unit 120 may determine the error amount (e.g., RMSE) of the profile TF with respect to the profile R by searching for the discrepancy part between the profile TF and the profile R in the capacity range of interest (shaded portion in FIG. 8).

The control unit 120 may calculate the length of the comparison voltage profile T and the length of the adjusted comparison voltage profile TF using various known methods. As an example, the control unit 120 may calculate the length of an arbitrary profile using the following formula.

[Formula]

$$ L = \int_a^b \sqrt{1 + f'(x)^2}\, dx $$

In the above formula, L means the length of an arbitrary profile, f(x) is a function representing an arbitrary profile (e.g. comparison voltage profile, adjusted comparison voltage profile), and f'(x) represents the derivative of f(x). Additionally, a and b are the lower limit and the upper limit of the capacity range for which the length is to be calculated.

The control unit 120 may calculate the length of each of the criterion voltage profile R, the comparison voltage profile T, and the adjusted comparison voltage profile TF using the above formula.

The control unit 120 may add the ratio of the length of the adjusted comparison voltage profile TF to the length of the comparison voltage profile T to the main adjustment information of the adjusted comparison voltage profile TF.

In the above-described manner, the control unit 120 may calculate first to $(m-1)^{th}$ main adjustment information by performing the adjustment operation for each of the first to $(m-1)^{th}$ comparison voltage profiles.

The control unit 120 may obtain (m-1) factors related to at least one adjustment operation among the first to fourth adjustment operations from the first to $(m-1)^{th}$ main adjustment information, and diagnose whether each of the first to $m^{th}$ batteries B1 to Bm is abnormal or whether the battery array 20 is abnormal based on the distribution of the obtained (m-1) factors.

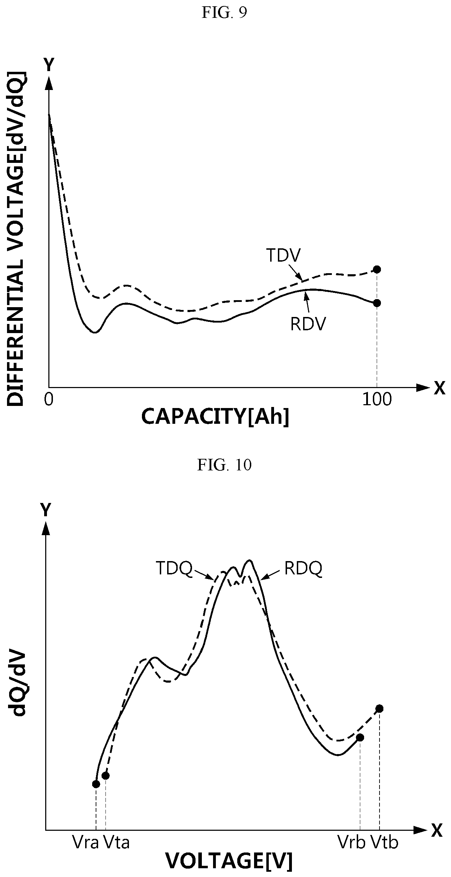

When diagnosing the battery array 20, the control unit 120 may additionally utilize the differential information of the criterion voltage profile and each of the first to $(m-1)^{th}$ comparison voltage profiles. Hereinafter, with reference to FIGS. 9 and 10, two embodiments of obtaining differential information for each voltage profile will be described.

FIG. 9 is a diagram referenced to explain the differential voltage profile generated from the voltage profile. In FIG. 9, the X-axis represents capacity, and the Y-axis represents differential voltage (dV/dQ).

The control unit 120 may generate an $i^{th}$ differential voltage profile from the $i^{th}$ voltage profile of the $i^{th}$ battery Bi. The $i^{th}$ differential voltage profile is a data set obtained from the $i^{th}$ voltage profile, and represents the relationship between (i) capacity and (ii) differential voltage (dV/dQ) of the $i^{th}$ voltage profile. dV/dQ is the ratio of the change amount (dV) of the voltage (V) to the unit capacity (dQ). In other words, the differential voltage (dV/dQ) is the rate of the change of voltage relative to capacity.

The control unit 120 may generate a criterion differential voltage profile from the criterion voltage profile and generate first to $(m-1)^{th}$ comparison differential voltage profiles from the first to $(m-1)^{th}$ comparison voltage profiles.

Referring to FIG. 9 together with FIG. 3, the profile RDV illustrates the criterion differential voltage profile obtained from the criterion voltage profile R of FIG. 3, and the profile TDV illustrates the comparison differential voltage profile obtained from the comparison voltage profile T of FIG. 3.

The control unit 120 may obtain first to $(m-1)^{th}$ adjusted comparison differential voltage profiles from the first to $(m-1)^{th}$ comparison differential voltage profiles by commonly applying the adjustment process including at least one of the first to fourth adjustment operations described above with reference to FIGS. 4 to 7 to the first to $(m-1)^{th}$ comparison differential voltage profiles. In other words, the voltage profile and the differential voltage profile has a difference only in that the unit of Y-axis is 'voltage (V)' and 'differential voltage (dV/dQ)'. Therefore, if only the unit of Y-axis in the above-described content for the first to fourth adjustment operations is replaced, the first to $(m-1)^{th}$ adjusted comparison differential voltage profiles may be obtained from the first to $(m-1)^{th}$ comparison differential voltage profiles.

The control unit 120 may generate first to $(m-1)^{th}$ sub adjustment information representing the adjustment level from the first to $(m-1)^{th}$ comparison differential voltage profiles to the first to $(m-1)^{th}$ adjusted comparison differential voltage profiles. The $j^{th}$ sub adjustment information may be a data set that defines how and to what extent the $j^{th}$ comparison differential voltage profile is adjusted to generate the $j^{th}$ adjusted comparison differential voltage profile. In this case, the adjustment amount of the first adjustment operation included in the $j^{th}$ sub adjustment information may be referred to as 'differential voltage shift factor' and the adjustment amount of the second adjustment operation may be referred to as 'differential voltage scaling factor'. The sub adjustment information obtained from the differential voltage profile may be referred to as 'differential voltage curve-based adjustment information'.

FIG. 10 is a diagram referenced to explain the differential capacity profile generated from the voltage profile. In FIG. 10, the X-axis represents voltage, and the Y-axis represents differential capacity (dQ/dV).

The control unit 120 may generate an $i^{th}$ differential capacity profile from the $i^{th}$ voltage profile. The $i^{th}$ differential capacity profile is a data set obtained from the $i^{th}$ voltage profile, and represents the relationship between (i) voltage and (ii) differential capacity (dQ/dV) of the $i^{th}$ voltage profile. dQ/dV is the ratio of the change amount (dQ) of the capacity (Q) to the unit voltage (dV). In other words, the differential capacity (dQ/dV) is the rate of the change of capacity with respect to voltage.

The control unit 120 may generate a criterion differential capacity profile from the criterion voltage profile and generate first to $(m-1)^{th}$ comparison differential capacity profiles from the first to $(m-1)^{th}$ comparison voltage profiles.

Referring to FIG. 10 together with FIG. 3, the profile RDQ illustrates the criterion differential capacity profile obtained from the criterion voltage profile R of FIG. 3, and the profile TDQ illustrates the comparison differential capacity profile obtained from the comparison voltage profile T of FIG. 3.

The control unit 120 may obtain first to $(m-1)^{th}$ adjusted comparison differential capacity profiles from the first to $(m-1)^{th}$ comparison differential capacity profiles by commonly applying the adjustment process including at least one of the first to fourth adjustment operations described above with reference to FIGS. 4 to 7 to the first to $(m-1)^{th}$ comparison differential capacity profiles. In other words, the voltage profile and the differential capacity profile are different in that the unit of X-axis is 'capacity' and 'voltage' and the unit of Y-axis is 'voltage' and 'differential capacity'. Therefore, if only the units of X-axis and Y-axis in the above-described content for the first to fourth adjustment operations are replaced, the first to $(m-1)^{th}$ adjusted comparison differential capacity profiles may be obtained from the first to $(m-1)^{th}$ comparison differential capacity profiles.

The control unit 120 may generate first to $(m-1)^{th}$ sub adjustment information representing the adjustment level from the first to $(m-1)^{th}$ comparison differential capacity profiles to the first to $(m-1)^{th}$ adjusted comparison differential capacity profiles. The $j^{th}$ sub adjustment information may be a data set that defines how and to what extent the $j^{th}$ comparison differential capacity profile is adjusted to generate the $j^{th}$ adjusted comparison differential capacity profile. The sub adjustment information obtained from the differential capacity profile may be referred to as 'differential capacity curve-based adjustment information'.

The control unit 120 diagnoses whether each of the first to $m^{th}$ batteries or the battery array 20 is abnormal, based on the first to $(m-1)^{th}$ main adjustment information. Depending on the implementation, the control unit 120 may additionally use the first to $(m-1)^{th}$ sub adjustment information when diagnosing an abnormality of each of the first to $m^{th}$ batteries B1 to Bm or abnormality of the battery array 20.

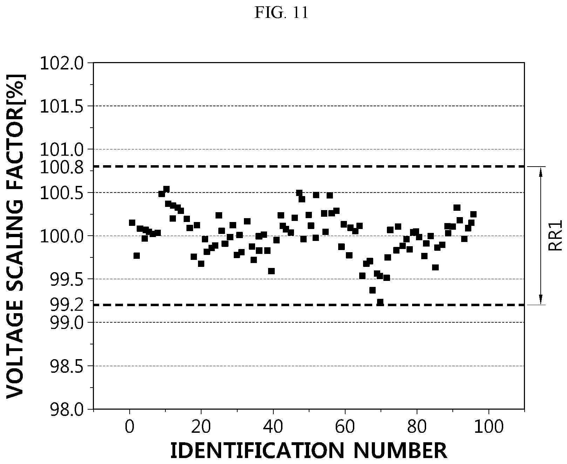

Below, embodiments in which the control unit 120 determines the state of the battery based on the calculated adjustment information and the criterion range will be described. For convenience of explanation, in FIGS. 11 to 14, the diagnosing method using the first to $(m-1)^{th}$ voltage scaling factors, which are the result of the second adjustment operation among the first to fourth adjustment operations, will be described. FIGS. 11 to 14 illustrate that the maximum value of the identification number is 100, that is, the battery array 20 includes a total of 100 batteries B1 to B100.

The control unit 120 may determine a representative value of the first to $(m-1)^{th}$ voltage scaling factors. The first to $(m-1)^{th}$ voltage scaling factors are the result of executing the above-described adjustment process for each of the first to $(m-1)^{th}$ comparison voltage profiles T and is associated with the second adjustment operation. For example, the representative value may be the average value or median value of the first to $(m-1)^{th}$ voltage scaling factors.

The control unit 120 may calculate the standard deviation and average value as distribution information of the first to $(m-1)^{th}$ voltage scaling factors, and set a criterion range for diagnosing whether the battery B is abnormal based on this.

Specifically, the control unit 120 may determine the criterion range so that the median value is equal to the representative value, the upper limit is equal to the value larger than the representative value by the allowable value, and the lower limit is equal to the value smaller than the representative value by the allowable value. Here, the allowable value may be equal to the standard deviation, or may be equal to the value obtained by multiplying the standard deviation by a predetermined positive coefficient.

As described above, the battery diagnosing apparatus 100 sets the criterion range using the distribution information, and thus has an advantage of reducing the possibility of misdiagnosis and improving the accuracy of abnormality diagnosis.

FIG. 11 is a diagram showing an example of the distribution of voltage scaling factors related to a specific adjustment operation of the adjustment process. In FIG. 11, the Y-axis represents the value of the voltage scaling factor, and the X-axis represents the battery identification number.

Referring to FIG. 11, the upper limit and the lower limit of the criterion range RR1 are 100.8% and 99.2%, respectively. From this, it can be seen that the average value of the first to $(m-1)^{th}$ voltage scaling factors is (100.8 + 99.2) / 2 = 100.0%, and the allowable value is 0.8%. As mentioned above, 100.0% is also a voltage scaling factor related to the criterion voltage profile.

Since all first to $(m-1)^{th}$ voltage scaling factors are located within the criterion range RR1, the control unit 120 may determine that all first to $m^{th}$ batteries B1 to Bm are normal. Additionally, since all first to $m^{th}$ batteries B1 to Bm are determined to be normal, the control unit 120 may determine that the battery array 20 is also normal.

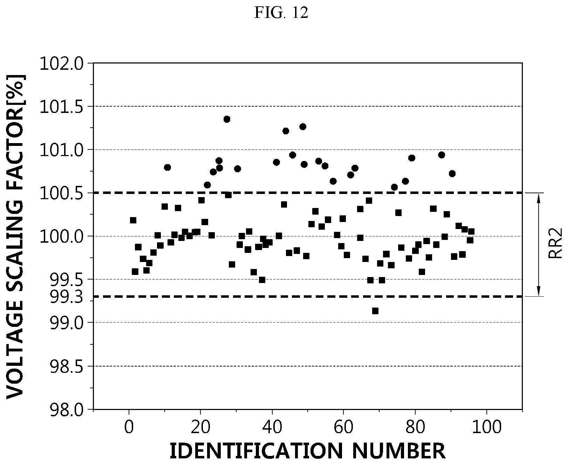

FIG. 12 is a diagram showing another example of the distribution of voltage scaling factors related to a specific adjustment operation of the adjustment process. In FIG. 12, the Y-axis represents the value of the voltage scaling factor, and the X-axis represents the battery identification number.

The upper limit and the lower limit of the criterion range RR2 in FIG. 12 are 100.5% and 99.3%, respectively. From this, it can be seen that the average value of the first to $(m-1)^{th}$ voltage scaling factors is (100.5 + 99.3) / 2 = 99.9% and the allowable value is 0.6%. When compared with the criterion range RR1 in FIG. 11, the average value is decreased by 0.1%p and the allowable value is decreased by 0.2%p, respectively.

In FIG. 12, unlike in FIG. 11, at least one of the plurality of adjustment information calculated by the control unit 120 for some voltage scaling factors is outside the criterion range RR2.

The control unit 120 may check the battery identification number associated with each voltage scaling factor outside the criterion range RR2 and determine that the battery of the confirmed battery identification number is abnormal. Additionally, the control unit 120 may determine that the battery array 20 is abnormal in response to the fact that the number of batteries determined to be abnormal is greater than or equal to the threshold value.

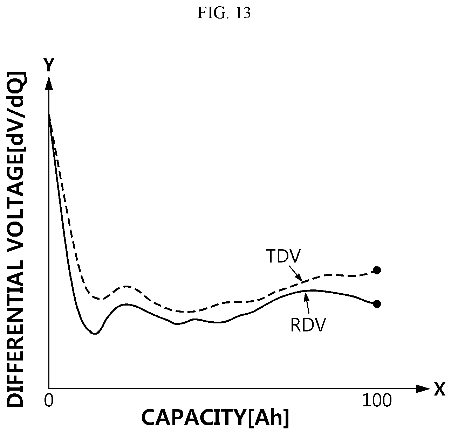

FIG. 13 is a diagram showing still another example of the distribution of voltage scaling factors related to a specific adjustment operation of the adjustment process. In FIG. 13, the Y-axis represents the value of the voltage scaling factor, and the X-axis represents the battery identification number.

The upper limit and the lower limit of the criterion range RR3 in FIG. 13 are 101.0% and 99.0%, respectively. From this, it can be seen that the average value of the first to $(m-1)^{th}$ voltage scaling factors is (101.0 + 99.0) / 2 = 100.0%, and the allowable value is 1.0%. When compared with the criterion range RR1 in FIG. 11, the average value is the same, but the allowable value is increased by 0.2%p.

Referring to FIG. 13, among the (m-1) voltage scaling factors, one voltage scaling factor F16 associated with the battery identification number 16 deviates from the criterion range RR3. Accordingly, the control unit 120 may determine that the battery with the battery identification number of 16 is abnormal.

The control unit 120 may determine the abnormality level of the battery that is determined to be abnormal. As an example, the abnormal level of the battery (i.e., B16) associated with the battery identification number 16 may have a predetermined positive correlation (e.g., proportional) to the separation amount from the criterion range RR3 of the voltage scaling factor F16 associated with the battery identification number 16. The voltage scaling factor F16 associated with the identification number 16 is smaller than the lower limit of the criterion range RR3, and thus the difference between the voltage scaling factor F16 and the lower limit of the criterion range RR3 may be calculated as the separation amount of the voltage scaling factor F16. Conversely, if the voltage scaling factor F16 is greater than the upper limit of the criterion range RR3, the difference between the voltage scaling factor F16 and the upper limit of the criterion range RR3 may be calculated as the separation amount of the voltage scaling factor F16. The larger the separation amount, the higher the abnormality level.

The control unit 120 may set the criterion range based on the criterion voltage profile R without calculating the representative value of the plurality of main adjustment information. In this case, the selected criterion voltage profile R may be the voltage profile of the criterion battery in an abnormal state, but even in this case, the control unit 120 may diagnose the state of the battery B. This will be explained with reference to FIG. 14.

FIG. 14 is a diagram showing still another example of the distribution of voltage scaling factors related to a specific adjustment operation of the adjustment process. In FIG. 14, the Y-axis represents the value of the voltage scaling factor, and the X-axis represents the battery identification number.

Referring to FIG. 14, the control unit 120 may diagnose abnormality of the first to $m^{th}$ batteries B1 to Bm or the battery array 20 by using a criterion range RR4 predetermined for a specific adjustment operation.

The criterion range RR4 is related to the second adjustment operation, and the median value is 100%, the upper limit and lower limit are 101.0% and 99.0%, respectively, and from this, it can be seen that the allowable value is 1%.

If only the criterion battery among the first to $m^{th}$ batteries B1 to Bm is abnormal, the first to $(m-1)^{th}$ comparison voltage profiles will have a large deviation from the criterion voltage profile R, and the voltage scaling factors of (m-1) batteries B excluding the criterion battery will be biased towards a range greater or less than 100%. FIG. 14 illustrates that all voltage scaling factors are biased upward, exceeding the upper limit of 101.0% of the criterion range RR4. In this case, the control unit 120 may diagnose whether the criterion battery is abnormal based on the number of voltage scaling factors that are outside the criterion range RR4 among the (m-1) voltage scaling factors. Naturally, if the number of voltage scaling factors (99 in FIG. 14) outside the criterion range RR4 is greater than or equal to a specific value (e.g., a natural number greater than or equal to m/3 and less than m/3+1), the criterion battery may be identified as abnormal.

So far, with reference to FIGS. 11 to 14, the diagnosis process using the voltage scaling factor associated with the second adjustment operation has been described. The diagnosis process may also be commonly applied to the diagnosis process using the distribution of the voltage scaling factors related to the second adjustment operation, the distribution of the voltage shift factors related to the first adjustment operation, the distribution of the capacity shift factors related to the third adjustment operation, and the distribution of the capacity scaling factors related to the fourth adjustment operation, respectively.

According to the above-described method, the battery diagnosing apparatus 100 may easily diagnose whether individual batteries are normal or abnormal by analyzing the adjustment results obtained for all batteries in a statistical manner, even if reference data used to detect abnormality of the batteries is not secured in advance.

The battery diagnosing apparatus 100 may identify a battery having an adjustment amount (e.g., voltage scaling factor) that is outside the criterion range. The battery diagnosing apparatus 100 may detect individual batteries to which an identification number related to an adjustment amount outside the criterion range for each adjustment operation is assigned in advance. In this case, it is possible to individually diagnose which battery among the first to $m^{th}$ batteries B1 to Bm connected in series is abnormal, and perform follow-up measurements for the abnormal battery such as user notification, discontinuation of use, or replacement. Additionally, the battery diagnosing apparatus 100 may diagnose whether the battery array 20 is abnormal depending on the number of batteries determined to be abnormal.

The adjustment process for the first to $m^{th}$ batteries B1 to Bm described above may be performed whenever a diagnosis-requiring event occurs. For example, if the elapsed time (time difference) from the previous charging completion time to the current charging start time is more than or equal to a predetermined criterion time (e.g., 1 week) and/or the cumulative charge/discharge capacity of the battery array 20 during the period from the previous charging completion time to the current charging start time is greater than or equal to a predetermined capacity (e.g., the design capacity of the battery array 20), the control unit 120 may determine that a diagnosis-requiring event has occurred. As another example, the control unit 120 may count the number of charging times for the battery pack 10 and determine that a diagnosis-requiring event has occurred whenever the number of charging increases by a predetermined criterion number.

The control unit 120 may select the criterion battery in the current diagnosis process based on the results of the previous diagnosis process. The criterion battery refers to a battery whose voltage profile is set to the criterion voltage profile.

For example, if only one diagnosis operation is performed among the first to fourth diagnosis operations in the previous diagnosis process, the control unit 120 may select a specific battery for which the adjustment amount of the specific diagnosis operation performed in the previous time is determined to be normal as the criterion battery.

As another example, if at least two diagnosis operations are performed among the first to fourth diagnosis operations in the previous diagnosis process, the control unit 120 may select a specific battery for which all adjustment amounts of the two or more adjustment operations performed in the previous time are determined to be normal as the criterion battery.

As still another example, when the fourth diagnosis operation is performed in the previous diagnosis process, the control unit 120 may select a battery associated with the capacity scaling factor closest to the average value or the median value among the adjustment amounts (i.e., first to $(m-1)^{th}$ capacity scaling factors) of the previous fourth diagnosis operation as the current criterion battery.

As described above, the control unit 120 may optimize the distribution of adjustment amounts obtained for each adjustment operation of the diagnosis process by selecting the criterion battery in the current diagnosis process based on the results of the previous diagnosis process.

When two or more batteries B are judged to be normal in the previous diagnosis process, the control unit 120 may select one battery, which has not selected or least selected as the criterion battery among the two or more batteries B, as the criterion battery in the current diagnosis process. As an example, among two or more batteries that have no history of being selected as a criterion battery, the battery with the smallest or largest identification number may be selected as the criterion battery.

On the other hand, the battery B has the characteristic that the lower its temperature, the slower the electrochemical reaction. For example, as the temperature of the battery increases, its internal resistance tends to decrease. Considering this, the control unit 120 may adjust the size of the criterion range for at least one of the first to fourth adjustment operations based on the temperature of the battery array 20.

Specifically, the measuring unit 110 may measure the temperature of the battery array 20. The temperature of the battery array 20 may be treated as representing the average temperature of the first to $m^{th}$ batteries B1 to Bm.

The control unit 120 may expand the criterion range to correspond to the difference between the measured temperature and the lower limit temperature, in response to that the measured temperature is less than the predetermined lower limit temperature.

The control unit 120 may reduce the criterion range to correspond to the difference between the measured temperature and the lower limit temperature, in response to that the measured temperature exceeds the predetermined upper limit temperature.

For example, it is assumed the criterion temperature range is +10 to +30°C. If the measured temperature is +20°C, the control unit 120 may maintain the criterion range of 99.0% to 101.0%. If the measured temperature is +1°C, the control unit 120 may expand the criterion range to correspond to a temperature difference of 9°C. If the measured temperature is +35°C, the control unit 120 may narrow the criterion range to correspond to a temperature difference of 5°C. Here, the median value of the criterion range (1/2 of the sum of the upper limit and the lower limit) may be kept as is. The relationship data between each of the upper limit temperature and/or the lower limit temperature of the criterion temperature range and the reduction rate and/or the expansion rate of the criterion range according to the temperature difference of the battery array 20 may be designed in a format such as a look-up table and pre-recorded in the memory 130.

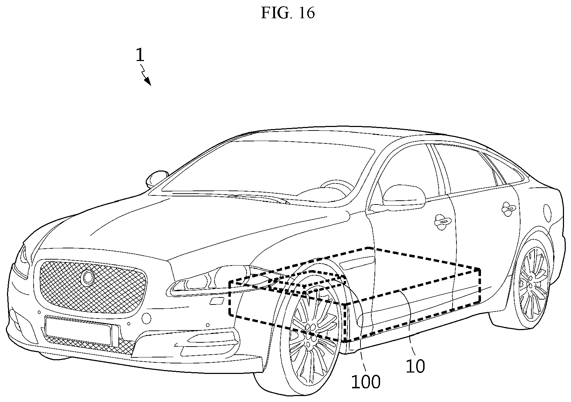

FIG. 15 is a diagram exemplarily showing a battery pack according to the present disclosure, and FIG. 16 is a diagram exemplarily showing an electric vehicle including the battery pack shown in FIG. 15.

Referring to FIG. 15, the battery pack 10 may include a pair of power terminals P+, P-, a battery array 20, and a battery diagnosing apparatus 100. The battery pack 10 may further include a relay 30 and a fuse 40. The charging and discharging unit 300 may be included in any one of the battery pack 10 and the electric vehicle 1.

At least some components of the battery diagnosing apparatus 100 according to the present disclosure may be implemented as conventional components included in the battery pack 10. For example, the measuring unit 110 of the battery diagnosing apparatus 100 according to the present disclosure may be implemented by a voltage sensor included in the battery pack 10.

The charging and discharging unit 300 may be configured to charge and/or discharge the battery array 20 in response to commands from the control unit 120. That is, the charging and discharging unit 300 may have only a charging function or may have both a charging function and a discharging function. In the process of charging and/or discharging the battery array 20 by the charging and discharging unit 300, the measuring unit 200 may measure voltage and current of each battery B included in the battery array 20.

Referring to FIG. 16, the battery pack 10 may be applied to an electric vehicle 1. That is, the electric vehicle 1 may include the battery diagnosis apparatus 100 according to the present disclosure described above. In particular, in the case of electric vehicle 1, the battery pack 10 as a power source is a very important component, so the battery diagnosing apparatus 100 according to the present disclosure may be more usefully applied. Of course, in addition to the battery pack 10, the electric vehicle 1 may further include a vehicle body, a vehicle control unit such as an ECU (electronic control unit), a motor, a connection terminal, a DC-DC converter, etc.

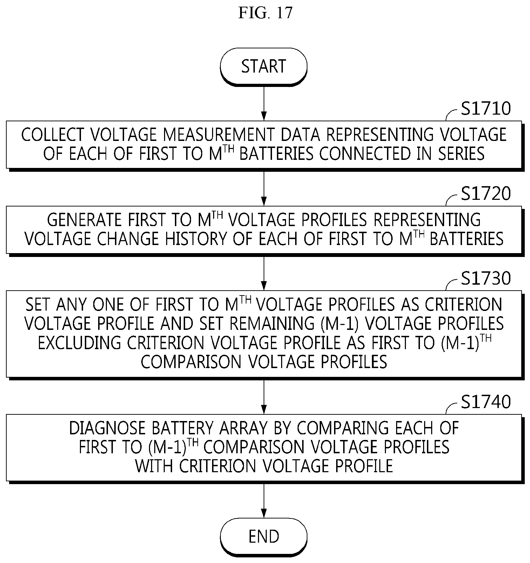

FIG. 17 is a flowchart schematically showing the battery diagnosing method according to an embodiment of the present disclosure. The method according to FIG. 17 may be executed by the battery diagnosing apparatus 100 whenever a diagnosis-requiring event occurs.

Referring to FIG. 17, in step S1710, the control unit 120 collects voltage measurement data representing the voltage of each of the first to $m^{th}$ batteries B1 to Bm connected in series from the measuring unit 110 while charging or discharging the battery array 20. The control unit 120 may collect current measurement data representing the current flowing through the battery array 20 from the measuring unit 110 in parallel with the collection of the voltage measurement data. If the accumulated capacity in step S1710 reaches a predetermined threshold capacity or the voltage of at least one battery among the first to $m^{th}$ batteries B1 to Bm in step S1710 reaches a predetermined upper limit voltage, the process may proceed from step S1710 to step S1720.

In step S1720, the control unit 120 generates first to $m^{th}$ voltage profiles representing the voltage change history of each of the first to $m^{th}$ batteries B1 to Bm. The $i^{th}$ voltage profile may be a time series of measurement values of voltage according to the time or capacity of the $i^{th}$ battery Bi.

In step S1730, the control unit 120 sets any one of the first to $m^{th}$ voltage profiles as the criterion voltage profile. Excluding the criterion voltage profile, the remaining (m-1) voltage profiles may be set as first to $(m-1)^{th}$ comparison voltage profiles.

In step S1740, the control unit 120 diagnoses the battery array by comparing each of the first to $(m-1)^{th}$ comparison voltage profiles with the criterion voltage profile.

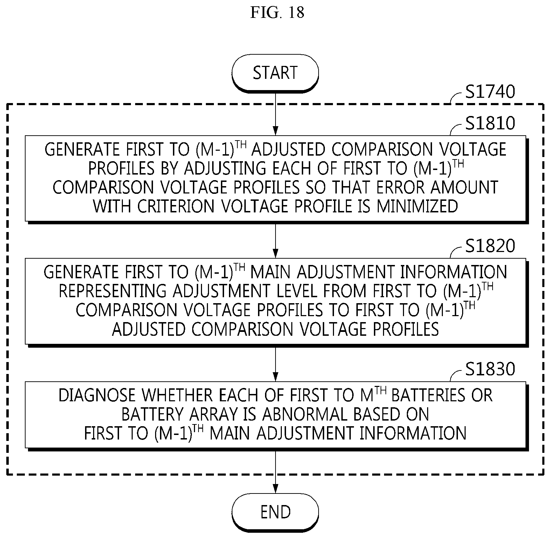

FIG. 18 is a flowchart exemplarily showing subroutines that can be included in step S1740 of FIG. 17.

Referring to FIG. 18, step S1740 may include steps S1810 to S1830 as its subroutines.

In step S1810, the control unit 120 may generate first to $(m-1)^{th}$ adjusted comparison voltage profiles by adjusting each of the first to $(m-1)^{th}$ comparison voltage profiles so that the error amount with the criterion voltage profile is minimized. In detail, an adjustment process including at least one of the first to fourth adjustment operations is executed for each of the first to $(m-1)^{th}$ comparison voltage profiles, and as a result, the first to $(m-1)^{th}$ adjusted comparison voltage profiles are generated. In other words, the $j^{th}$ adjusted comparison voltage profile is obtained from the $j^{th}$ comparison voltage profile.

In step S1820, the control unit 120 generates first to $(m-1)^{th}$ main adjustment information representing the adjustment level from the first to $(m-1)^{th}$ comparison voltage profiles to the first to $(m-1)^{th}$ adjusted comparison voltage profiles. The $j^{th}$ main adjustment information includes at least one of the $j^{th}$ voltage shift factor, which is the adjustment amount by the first adjustment operation, the $j^{th}$ voltage scaling factor, which is the adjustment amount by the second adjustment operation, the $j^{th}$ capacity shift factor, which is the adjustment amount by the third adjustment operation, and the $j^{th}$ capacity scaling factor, which is the adjustment amount by the fourth adjustment operation.

In step S1830, the control unit 120 diagnoses whether each of the first to $m^{th}$ batteries B1 to Bm or the battery array 20 is abnormal based on the first to $(m-1)^{th}$ main adjustment information. In detail, the control unit 120 may detect abnormality of at least one of the battery B and the battery array 20 by analyzing the distribution of adjustment amounts of at least one adjustment operation included in the first to $(m-1)^{th}$ main adjustment information.

As an example, the control unit 120 may diagnose whether each of the first to $m^{th}$ batteries B1 to Bm is abnormal or whether the battery array 20 is abnormal, based on at least one of the result data set of the first adjustment operation, the result data set of the second adjustment operation, the result data set of the third adjustment operation, and the result data set of the fourth adjustment operation.

Here, the result data set of the first adjustment operation refers to the first to $(m-1)^{th}$ voltage shift factors. The result data set of the second adjustment operation refers to the first to $(m-1)^{th}$ voltage scaling factors. The result data set of the third adjustment operation refers to the first to $(m-1)^{th}$ capacity shift factors. The result data set of the fourth adjustment operation refers to the first to $(m-1)^{th}$ capacity scaling factors.

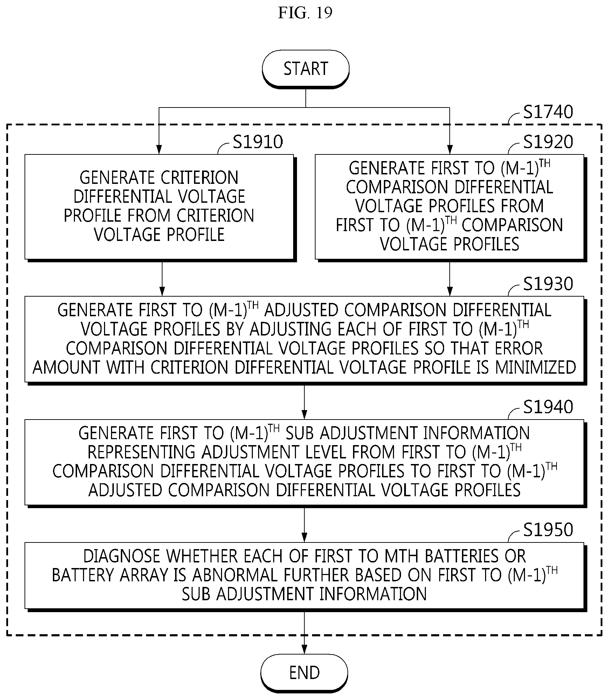

FIG. 19 is a flowchart showing an example of subroutines that can be added to step S1740 of FIG. 17.

Referring to FIG. 19, step S1740 may include steps S1910 to S1950 as its subroutines. The method of FIG. 19 may be executed in parallel with the method of FIG. 18 or may be executed after completion of the method of FIG. 18.

In step S1910, the control unit 120 generates a criterion differential voltage profile from the criterion voltage profile.

In step S1920, the control unit 120 generates first to $(m-1)^{th}$ comparison differential voltage profiles from the first to $(m-1)^{th}$ comparison voltage profiles.

In step S1930, the control unit 120 generates first to $(m-1)^{th}$ adjusted comparison differential voltage profiles by adjusting each of the first to $(m-1)^{th}$ comparison differential voltage profiles so that the error amount with the criterion differential voltage profile is minimized.

In step S1940, the control unit 120 generates first to $(m-1)^{th}$ sub adjustment information representing adjustment levels from the first to $(m-1)^{th}$ comparison differential voltage profiles to the first to $(m-1)^{th}$ adjusted comparison differential voltage profiles.

In step S1950, the control unit 120 diagnoses whether each of the first to $m^{th}$ batteries B1 to Bm or the battery array 20 is abnormal based on the first to $(m-1)^{th}$ sub adjustment information further based on the differential voltage curve.

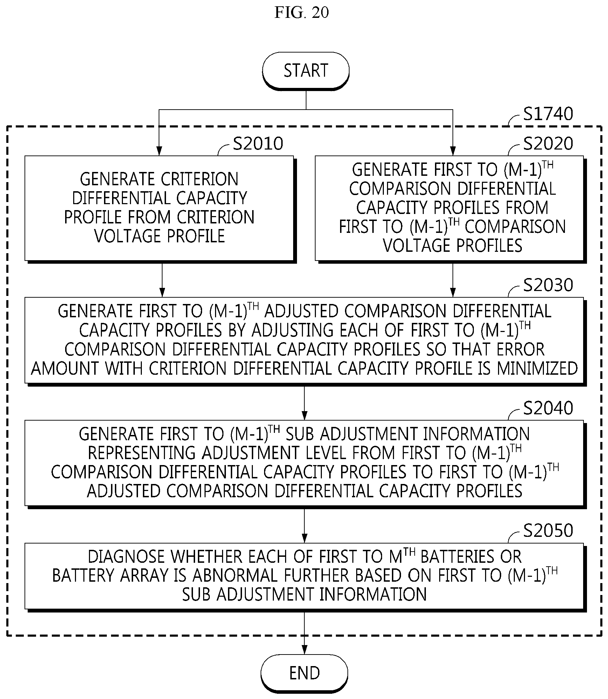

FIG. 20 is a flowchart showing another example of subroutines that can be added to step S1740 of FIG. 17.

Referring to FIG. 20, step S1740 may include steps S2010 to S2050 as its subroutines. The method of FIG. 20 may be executed in parallel with the method of FIG. 18 and/or the method of FIG. 19, or may be executed after completion of at least one of the method of FIG. 18 and the method of FIG. 19.

In step S2010, the control unit 120 generates a criterion differential capacity profile from the criterion voltage profile.

In step S2020, the control unit 120 generates first to (m-1)$^{th}$ comparison differential capacity profiles from the first to (m-1)$^{th}$ comparison voltage profiles.

In step S2030, the control unit 120 generates first to (m-1)$^{th}$ adjusted comparison differential capacity profiles by adjusting each of the first to (m-1)$^{th}$ comparison differential capacity profiles so that the error amount with the criterion differential capacity profile is minimized.

In step S2040, the control unit 120 generates first to (m-1)$^{th}$ sub adjustment information representing adjustment levels from the first to (m-1)$^{th}$ comparison differential capacity profiles to the first to (m-1)$^{th}$ adjusted comparison differential capacity profiles. The first to (m-1)$^{th}$ sub adjustment information in the method of FIG. 20 is adjustment information based on the differential capacity curve, which is distinguished from the fact that the first to (m-1)$^{th}$ sub adjustment information in the method of FIG. 19 described above is adjustment information based on the differential voltage curve.

In step S2050, the control unit 120 diagnoses whether each of the first to m$^{th}$ batteries B1 to Bm or the battery array 20 is abnormal, further based on the first to (m-1)$^{th}$ sub adjustment information based on the differential capacity curve.

When all the methods according to FIGS. 18 to 20 are executed, the control unit 120 may finally determine each battery commonly diagnosed as abnormal by the multiple methods as an abnormal battery, and assign an abnormality confirmation flag to the identification number of the battery determined as abnormal.

The control unit 120 may determine that each battery that is diagnosed as abnormal in one or both of the three methods according to FIGS. 18 to 20 is normal, but assign an abnormality suspicion flag to the identification number of the corresponding battery.

The control unit 120 may finally determine each battery diagnosed as normal in all three methods according to FIGS. 18 to 20 as a normal battery, and assign a normal confirmation flag to the identification number of the battery determined to be normal.

The control unit 120 may determine the diagnostic sequence for the first to m$^{th}$ batteries B1 to Bm in the current diagnosis process, according to the diagnosis flag (abnormal confirmation flag, suspicion abnormality flag, or normal confirmation flag) assigned to each of the first to m$^{th}$ batteries B1 to Bm in the previous diagnosis process. The control unit 120 may diagnose whether the battery of the identification number to which the abnormality suspicion flag is assigned is abnormal, rather than the battery of the identification number to which the normal confirmation flag is assigned in the previous diagnosis process. For example, in the previous diagnosis process, if the suspicion abnormality flag is given to the identification number of the first battery B1 and the normal confirmation flag is given to the identification number of the second battery B2, the control unit 120 may check whether the first battery B1 is abnormal by comparing the adjustment amount related to the first battery B1 with the criterion range prior to the adjustment amount related to the second battery B2.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings.

**Claims**

1. A battery diagnosing apparatus (100) for a battery array (20) including first to m$^{th}$ batteries connected in series, wherein m is a natural number of 3 or more, the battery diagnosing apparatus (100) comprising:

   a measuring unit (110, 200) configured to detect voltage of each of the first to m$^{th}$ batteries; **characterized by** a control unit (120) configured to generate first to m$^{th}$ voltage profiles representing a voltage change history of each of the first to m$^{th}$ batteries, based on voltage measurement data collected from the measuring unit (110, 200) during charging or discharging of the battery array (20), wherein the control unit (120) is configured to diagnose the battery array (20) by comparing each of first to (m-1)$^{th}$ comparison voltage profiles with a criterion voltage profile, wherein the criterion voltage profile is one of the first to m$^{th}$ voltage profiles, and the first to (m-1)$^{th}$ comparison voltage profiles are remaining (m-1) voltage profiles other than the criterion voltage profile.

2. The battery diagnosing apparatus (100) according to claim 1, wherein the control unit (120) is configured to:

generate first to $(m-1)^{th}$ adjusted comparison voltage profiles by adjusting the first to $(m-1)^{th}$ comparison voltage profiles respectively, so that an error amount of each of the first to $(m-1)^{th}$ adjusted comparison voltage profiles with the criterion voltage profile is minimized,
generate first to $(m-1)^{th}$ main adjustment information representing adjustment levels from the first to $(m-1)^{th}$ comparison voltage profiles to the first to $(m-1)^{th}$ adjusted comparison voltage profiles, and
diagnose the battery array (20) based on the first to $(m-1)^{th}$ main adjustment information.

3. The battery diagnosing apparatus (100) according to claim 2, wherein the control unit (120) is configured to determine the sum of squares or the root mean square error of the voltage difference between a $j^{th}$ adjusted comparison voltage profile among the first to $(m-1)^{th}$ adjusted comparison voltage profiles and the criterion voltage profile as the error amount between the $j^{th}$ comparison voltage profile and the criterion voltage profile, wherein j is a natural number less than m.

4. The battery diagnosing apparatus (100) according to claim 2, wherein the control unit (120) is configured to determine a $j^{th}$ voltage shift factor from the $j^{th}$ comparison voltage profile to the $j^{th}$ adjusted comparison voltage profile, and
wherein among the first to $(m-1)^{th}$ main adjustment information, the $j^{th}$ main adjustment information includes the $j^{th}$ voltage shift factor.

5. The battery diagnosing apparatus (100) according to claim 4, wherein the control unit (120) is configured to diagnose abnormality of each of the first to $m^{th}$ batteries or the battery array (20) based on a distribution of first to $(m-1)^{th}$ voltage shift factors of the first to $(m-1)^{th}$ main adjustment information.

6. The battery diagnosing apparatus (100) according to claim 2, wherein the control unit (120) is configured to determine a $j^{th}$ voltage scaling factor from the $j^{th}$ comparison voltage profile to the $j^{th}$ adjusted comparison voltage profile, and
wherein among the first to $(m-1)^{th}$ main adjustment information, the $j^{th}$ main adjustment information includes the $j^{th}$ voltage scaling factor.

7. The battery diagnosing apparatus (100) according to claim 6, wherein the control unit (120) is configured to diagnose abnormality of each of the first to $m^{th}$ batteries or the battery array (20) based on a distribution of first to $(m-1)^{th}$ voltage scaling factors of the first to $(m-1)^{th}$ main adjustment information.

8. The battery diagnosing apparatus (100) according to claim 2, wherein the control unit (120) is configured to:

generate a criterion differential voltage profile from the criterion voltage profile,
generate first to $(m-1)^{th}$ comparison differential voltage profiles from the first to $(m-1)^{th}$ comparison voltage profiles,
generate first to $(m-1)^{th}$ adjusted comparison differential voltage profiles by adjusting the first to $(m-1)^{th}$ comparison differential voltage profiles respectively, so that an error amount of each of the first to $(m-1)^{th}$ adjusted comparison differential voltage profiles with the criterion differential voltage profile is minimized,
generate first to $(m-1)^{th}$ sub adjustment information representing adjustment levels from the first to $(m-1)^{th}$ comparison differential voltage profiles to the first to $(m-1)^{th}$ adjusted comparison differential voltage profiles, and
diagnose abnormality of each of the first to $m^{th}$ batteries or the battery array (20) further based on the first to $(m-1)^{th}$ sub adjustment information.

9. The battery diagnosing apparatus (100) according to claim 8, wherein the control unit (120) is configured to determine a $j^{th}$ differential voltage shift factor from the $j^{th}$ comparison differential voltage profile to the $j^{th}$ adjusted comparison differential voltage profile, and
wherein among the first to $(m-1)^{th}$ sub adjustment information, the $j^{th}$ sub adjustment information includes the $j^{th}$ differential voltage shift factor.

10. The battery diagnosing apparatus (100) according to claim 8, wherein the control unit (120) is configured to determine a $j^{th}$ differential voltage scaling factor from the $j^{th}$ comparison differential voltage profile to the $j^{th}$ adjusted comparison differential voltage profile, and
wherein among the first to $(m-1)^{th}$ sub adjustment information, the $j^{th}$ sub adjustment information includes $j^{th}$ differential voltage scaling factor.

11. A battery pack (10), comprising the battery diagnosing apparatus (100) according to any one of claims 1 to 10.

12. An electric vehicle, comprising the battery pack (10) according to claim 11.

13. A battery diagnosing method for a battery array (20) including first to $m^{th}$ batteries connected in series, wherein m is a natural number of 3 or more, the battery diagnosing method comprising:

collecting voltage measurement data representing voltage of each of the first to $m^{th}$ batteries during charging or discharging of the battery array (20);

**characterized by**

generating first to m$^{th}$ voltage profiles representing a voltage change history of each of the first to m$^{th}$ batteries, based on the voltage measurement data; and

diagnosing the battery array (20) by comparing each of first to (m-1)$^{th}$ comparison voltage profiles with a criterion voltage profile, wherein the criterion voltage profile is one of the first to m$^{th}$ voltage profiles, and the first to (m-1)$^{th}$ comparison voltage profiles are remaining (m-1) voltage profiles other than the criterion voltage profile.

14. The battery diagnosing method according to claim 13, wherein the step of diagnosing the battery array (20) includes:

generating first to (m-1)$^{th}$ adjusted comparison voltage profiles by adjusting the first to (m-1)$^{th}$ comparison voltage profiles respectively, so that an error amount of each of the first to (m-1)$^{th}$ adjusted comparison voltage profiles with the criterion voltage profile is minimized;

generating first to (m-1)$^{th}$ main adjustment information representing adjustment levels from the first to (m-1)$^{th}$ comparison voltage profiles to the first to (m-1)$^{th}$ adjusted comparison voltage profiles; and

diagnosing abnormality of each of the first to m$^{th}$ batteries or the battery array (20) based on the first to (m-1)$^{th}$ main adjustment information.

15. The battery diagnosing method according to claim 13, further comprising:

generating a criterion differential voltage profile from the criterion voltage profile;

generating first to (m-1)$^{th}$ comparison differential voltage profiles from the first to (m-1)$^{th}$ comparison voltage profiles;

generating first to (m-1)$^{th}$ adjusted comparison differential voltage profiles by adjusting the first to (m-1)$^{th}$ comparison differential voltage profiles respectively, so that an error amount of each of the first to (m-1)$^{th}$ adjusted comparison differential voltage profiles with the criterion differential voltage profile is minimized; and

generating first to (m-1)$^{th}$ sub adjustment information representing adjustment levels from the first to (m-1)$^{th}$ comparison differential voltage profiles to the first to (m-1)$^{th}$ adjusted comparison differential voltage profiles,

wherein the step of diagnosing the battery array (20) diagnoses the battery array (20) further based on the first to (m-1)$^{th}$ sub adjustment information.

**Patentansprüche**

1. Batteriediagnosevorrichtung (100) für eine Batterieanordnung (20), die erste bis m-te Batterien umfasst, die in Reihe geschaltet sind, wobei m eine natürliche Zahl von 3 oder mehr ist, wobei die Batteriediagnosevorrichtung (100) umfasst:

eine Messeinheit (110, 200), die konfiguriert ist, um eine Spannung von jeder der ersten bis m-ten Batterien zu erfassen;

**gekennzeichnet durch**

eine Steuereinheit (120), die konfiguriert ist, um erste bis m-te Spannungsprofile zu erzeugen, die einen Spannungsänderungsverlauf von jeder der ersten bis m-ten Batterien darstellen, basierend auf Spannungsmessdaten, die von der Messeinheit (110, 200) während des Ladens oder Entladens der Batterieanordnung (20) gesammelt werden,

wobei die Steuereinheit (120) konfiguriert ist, um die Batterieanordnung (20) durch Vergleichen jedes der ersten bis (m-1)-ten Vergleichsspannungsprofile mit einem Kriteriumsspannungsprofil zu diagnostizieren, wobei das Kriteriumsspannungsprofil eines der ersten bis m-ten Spannungsprofile ist und die ersten bis (m-1)-ten Vergleichsspannungsprofile verbleibende (m-1) Spannungsprofile sind, die sich von dem Kriteriumsspannungsprofil unterscheiden.

2. Batteriediagnosevorrichtung (100) nach Anspruch 1, wobei die Steuereinheit (120) konfiguriert ist, um:

erste bis (m-1)-te angepasste Vergleichsspannungsprofile durch jeweiliges Anpassen der ersten bis (m-1)-ten Vergleichsspannungsprofile zu erzeugen, so dass ein Fehlerbetrag von jedem der ersten bis (m-1)-ten angepassten Vergleichsspannungsprofile mit dem Kriteriumsspannungsprofil minimiert wird,

erste bis (m-1)-te Hauptanpassungsinformationen zu erzeugen, die Anpassungspegel von den ersten bis (m-1)-ten Vergleichsspannungsprofilen zu den ersten bis (m-1)-ten angepassten Vergleichsspannungsprofilen darstellen, und

die Batterieanordnung (20) basierend auf den ersten bis (m-1)-ten Hauptanpassungsinformationen zu diagnostizieren.

3. Batteriediagnosevorrichtung (100) nach Anspruch 2, wobei die Steuereinheit (120) konfiguriert ist, um die Summe von Quadraten oder den quadratischen Mittelwert der Spannungsdifferenz zwischen einem j-ten angepassten Vergleichsspannungsprofil unter den ersten bis (m-1)-ten angepassten Vergleichsspannungsprofilen und dem Kriteriumsspannungsprofil als den Fehlerbetrag zwischen dem j-ten Vergleichsspannungsprofil und dem Kriteriumsspannungsprofil zu bestimmen, wobei j eine natürliche Zahl kleiner als m ist.

4. Batteriediagnosevorrichtung (100) nach Anspruch 2, wobei die Steuereinheit (120) konfiguriert ist, um einen j-ten Spannungsverschiebungsfaktor von dem j-ten Vergleichsspannungsprofil zu dem j-ten angepassten Vergleichsspannungsprofil zu bestimmen, und wobei unter den ersten bis (m-1)-ten Hauptanpassungsinformationen die j-ten Hauptanpassungsinformationen den j-ten Spannungsverschiebungsfaktor beinhalten.

5. Batteriediagnosevorrichtung (100) nach Anspruch 4, wobei die Steuereinheit (120) konfiguriert ist, um eine Abnormalität von jeder der ersten bis m-ten Batterien oder der Batterieanordnung (20) basierend auf einer Verteilung von ersten bis (m-1)-ten Spannungsverschiebungsfaktoren der ersten bis (m-1)-ten Hauptanpassungsinformationen zu diagnostizieren.

6. Batteriediagnosevorrichtung (100) nach Anspruch 2, wobei die Steuereinheit (120) konfiguriert ist, um einen j-ten Spannungsskalierungsfaktor von dem j-ten Vergleichsspannungsprofil zu dem j-ten angepassten Vergleichsspannungsprofil zu bestimmen, und wobei unter den ersten bis (m-1)-ten Hauptanpassungsinformationen die j-ten Hauptanpassungsinformationen den j-ten Spannungsskalierungsfaktor beinhalten.

7. Batteriediagnosevorrichtung (100) nach Anspruch 6, wobei die Steuereinheit (120) konfiguriert ist, um eine Abnormalität von jeder der ersten bis m-ten Batterien oder der Batterieanordnung (20) basierend auf einer Verteilung von ersten bis (m-1)-ten Spannungsskalierungsfaktoren der ersten bis (m-1)-ten Hauptanpassungsinformationen zu diagnostizieren.

8. Batteriediagnosevorrichtung (100) nach Anspruch 2, wobei die Steuereinheit (120) konfiguriert ist, um:

ein Kriteriumsdifferenzspannungsprofil aus dem Kriteriumsspannungsprofil zu erzeugen, erste bis (m-1)-te Vergleichsdifferenzspannungsprofile aus den ersten bis (m-1)-ten Vergleichsspannungsprofilen zu erzeugen, erste bis (m-1)-te angepasste Vergleichsdifferenzspannungsprofile durch jeweiliges Anpassen der ersten bis (m-1)-ten Vergleichsdifferenzspannungsprofile zu erzeugen, so dass ein Fehlerbetrag von jedem der ersten bis (m-1)-ten angepassten Vergleichsdifferenzspannungsprofile mit dem Kriteriumsdifferenzspannungsprofil minimiert wird, erste bis (m-1)-te Unteranpassungsinformationen zu erzeugen, die Anpassungspegel von den ersten bis (m-1)-ten Vergleichsdifferenzspannungsprofilen zu den ersten bis (m-1)-ten angepassten Vergleichsdifferenzspannungsprofilen darstellen, und eine Abnormalität von jeder der ersten bis m-ten Batterien oder der Batterieanordnung (20) ferner basierend auf den ersten bis (m-1)-ten Unteranpassungsinformationen zu diagnostizieren.

9. Batteriediagnosevorrichtung (100) nach Anspruch 8, wobei die Steuereinheit (120) konfiguriert ist, um einen j-ten Differenzspannungsverschiebungsfaktor von dem j-ten Vergleichsdifferenzspannungsprofil zu dem j-ten angepassten Vergleichsdifferenzspannungsprofil zu bestimmen, und wobei unter den ersten bis (m-1)-ten Unteranpassungsinformationen die j-ten Unteranpassungsinformationen den j-ten Differenzspannungsverschiebungsfaktor beinhalten.

10. Batteriediagnosevorrichtung (100) nach Anspruch 8, wobei die Steuereinheit (120) konfiguriert ist, um einen j-ten Differenzspannungsskalierungsfaktor von dem j-ten Vergleichsdifferenzspannungsprofil zu dem j-ten angepassten Vergleichsdifferenzspannungsprofil zu bestimmen, und wobei unter den ersten bis (m-1)-ten Unteranpassungsinformationen die j-ten Unteranpassungsinformationen den j-ten Differenzspannungsskalierungsfaktor beinhalten.

11. Batteriepack (10), umfassend die Batteriediagnosevorrichtung (100) nach einem der Ansprüche 1 bis 10.

12. Elektrofahrzeug, umfassend das Batteriepack (10) nach Anspruch 11.

13. Batteriediagnoseverfahren für eine Batterieanordnung (20), die erste bis m-te Batterien umfasst, die in Reihe geschaltet sind, wobei m eine natürliche Zahl von 3 oder mehr ist, wobei das Batteriediagnoseverfahren umfasst:

Sammeln von Spannungsmessdaten, die eine Spannung von jeder der ersten bis m-ten Batterien während des Ladens oder Entladens der Batterieanordnung (20) darstellen;
**gekennzeichnet durch**
Erzeugen erster bis m-ter Spannungsprofile, die einen Spannungsänderungsverlauf von jeder der ersten bis m-ten Batterien darstellen, basierend auf den Spannungsmessdaten; und

Diagnostizieren der Batterieanordnung (20) durch Vergleichen jedes der ersten bis (m-1)-ten Vergleichsspannungsprofile mit einem Kriteriumsspannungsprofil, wobei das Kriteriumsspannungsprofil eines der ersten bis m-ten Spannungsprofile ist und die ersten bis (m-1)-ten Vergleichsspannungsprofile verbleibende (m-1) Spannungsprofile sind, die sich von dem Kriteriumsspannungsprofil unterscheiden.

14. Batteriediagnoseverfahren nach Anspruch 13, wobei der Schritt des Diagnostizierens der Batterieanordnung (20) umfasst:

Erzeugen erster bis (m-1)-ter angepasster Vergleichsspannungsprofile durch jeweiliges Anpassen der ersten bis (m-1)-ten Vergleichsspannungsprofile, so dass ein Fehlerbetrag von jedem der ersten bis (m-1)-ten angepassten Vergleichsspannungsprofile mit dem Kriteriumsspannungsprofil minimiert wird;
Erzeugen erster bis (m-1)-ter Hauptanpassungsinformationen, die Anpassungspegel von den ersten bis (m-1)-ten Vergleichsspannungsprofilen zu den ersten bis (m-1)-ten angepassten Vergleichsspannungsprofilen darstellen; und
Diagnostizieren einer Abnormalität von jeder der ersten bis m-ten Batterien oder der Batterieanordnung (20) basierend auf den ersten bis (m-1)-ten Hauptanpassungsinformationen.

15. Batteriediagnoseverfahren nach Anspruch 13, ferner umfassend:

Erzeugen eines Kriteriumsdifferenzspannungsprofils aus dem Kriteriumsspannungsprofil;
Erzeugen erster bis (m-1)-ter Vergleichsdifferenzspannungsprofile aus den ersten bis (m-1)-ten Vergleichsspannungsprofilen;
Erzeugen erster bis (m-1)-ter angepasster Vergleichsdifferenzspannungsprofile durch jeweiliges Anpassen der ersten bis (m-1)-ten Vergleichsdifferenzspannungsprofile, so dass ein Fehlerbetrag von jedem der ersten bis (m-1)-ten angepassten Vergleichsdifferenzspannungsprofile mit dem Kriteriumsdifferenzspannungsprofil minimiert wird; und
Erzeugen erster bis (m-1)-ter Unteranpassungsinformationen, die Anpassungspegel von den ersten bis (m-1)-ten Vergleichsdifferenzspannungsprofilen zu den ersten bis (m-1)-ten angepassten Vergleichsdifferenzspannungsprofilen darstellen,
wobei der Schritt des Diagnostizierens der Batterieanordnung (20) die Batterieanordnung (20) ferner basierend auf den ersten bis (m-1)-ten Unteranpassungsinformationen diagnostiziert.

## Revendications

1. Appareil de diagnostic de batterie (100) pour un réseau de batteries (20) composé d'une première à de m$^{ème}$ batteries montées en série, m étant un entier 3 ou supérieur, l'appareil de diagnostic de batterie (100) comprenant :

un appareil de mesure (110, 200) configuré pour détecter la tension de chacune de la première aux m$^{èmes}$ batteries ;
**caractérisé par**
un module de commande (120) configuré pour générer des profils de tension de la première à aux m$^{èmes}$ représentant un historique des variations de tension de chacune de la première aux m$^{èmes}$ batteries d'après des données de mesure de la tension recueillies de l'appareil de mesure (110, 200) au cours de la charge et de la décharge du réseau de batteries (20),
le module de commande (120) étant configuré pour effectuer un diagnostic du réseau de batteries (20) en comparant les profils de tension de comparaison de chacune de la première aux (m-1)$^{èmes}$ avec un profil de tension critère, le profil de tension critère étant un des profils de tension de la première aux m$^{èmes}$, et les profils de tension de comparaison de la première aux (m-1)$^{èmes}$ étant les profils de tension restants (m-1) autres que le profil de tension critère.

2. Appareil de diagnostic de batterie (100) selon la revendication 1, l module de commande (120) étant configuré :

pour générer des profils de tension de comparaison ajustés de la première aux (m-1)$^{èmes}$ en ajustant respectivement les profils de tension de comparaison de la première aux (m-1)$^{èmes}$, de façon à minimiser une valeur d'erreur de chacun des profils de tension de comparaison ajustés de la première aux (m-1)$^{èmes}$ avec le profil de tension critère,
pour générer des informations d'ajustage principales de la première aux (m-1)$^{èmes}$ représentant des niveaux d'ajustage des profils de tension de comparaison de la première aux (m-1)$^{èmes}$ aux profils de tension de comparaison ajustés de la première aux (m-1)$^{èmes}$, et
pour diagnostiquer le réseau de batteries (20) d'après les informations d'ajustage principales de la première aux (m-1)$^{èmes}$.

3. Appareil de diagnostic de batterie (100) selon la revendication 2, le module de commande (120) étant configuré pour établir la somme des carrés ou l'erreur quadratique moyenne de la différence de tension entre un $j^{ème}$ profil de tension de comparaison ajusté parmi les profils de tension de comparaison ajustés de la première aux $(m-1)^{èmes}$ et le profil de tension critère en tant que valeur d'erreur entre le $j^{ème}$ profil de tension de comparaison et le profil de tension critère, j étant un entier naturel inférieur à m.

4. Appareil de diagnostic de batterie (100) selon la revendication 2, le module de commande (120) étant configuré pour établir un $j^{ème}$ facteur de décalage de tension du $j^{ème}$ profil de tension de comparaison au $j^{ème}$ profil de tension de comparaison ajusté, et parmi les informations d'ajustage principales de la première aux $(m-1)^{èmes}$, les $j^{èmes}$ informations d'ajustage principales comprenant le $j^{ème}$ facteur de décalage de tension.

5. Appareil de diagnostic de batterie (100) selon la revendication 4, le module de commande (120) étant configuré pour diagnostiquer une anomalie relative à chacune des batteries, de la première à la $m^{ème}$, ou au réseau de batteries (20) d'après une distribution des facteurs de décalage de tension de la première aux $(m-1)^{èmes}$, des informations d'ajustage principales pour la première aux $(m-1)^{èmes}$.

6. Appareil de diagnostic de batterie (100) selon la revendication 2, le module de commande (120) étant configuré pour établir un $j^{ème}$ facteur de mise à l'échelle de tension du $j^{ème}$ profil de tension de comparaison au $j^{ème}$ profil de tension de comparaison ajusté, et parmi les informations d'ajustage principales pour la première aux $(m-1)^{èmes}$, les $j^{ème}$ informations d'ajustage principales comprenant le $j^{ème}$ facteur de mise à l'échelle de tension.

7. Appareil de diagnostic de batterie (100) selon la revendication 6, le module de commande (120) étant configuré pour diagnostiquer une anomalie relative à chacune de la première aux $m^{ème}$ batteries, ou du réseau de batteries (20), d'après une distribution des facteurs de mise à l'échelle de la tension de la première aux $(m-1)^{èmes}$ des informations d'ajustage principales pour la première aux $(m-1)^{èmes}$.

8. Appareil de diagnostic de batterie (100) selon la revendication 2, le module de commande (120) étant configuré :

pour générer un profil de tension différentielle critère d'après le profil de tension critère,
pour générer des profils de tension différentielle de comparaison de la première aux $(m-1)^{èmes}$, d'après les profils de tension de comparaison de la première aux $(m-1)^{èmes}$.

pour générer des profils de tension différentielle de comparaison ajustés de la première aux $(m-1)^{èmes}$ en ajustant les profils de tension différentielle de comparaison de la première aux $(m-1)^{èmes}$ respectivement de façon à minimiser une valeur d'erreur de chacun des profils de tension de comparaison ajustés de la première aux $(m-1)^{èmes}$ avec le profil de tension différentielle critère,
pour générer des informations de sous-ajustage de la première aux $(m-1)^{èmes}$ représentant des niveaux d'ajustage des profils de tension différentielle de comparaison de la première aux $(m-1)^{èmes}$ avec des profils de tension différentielle de comparaison ajustés de la première aux $(m-1)^{èmes}$, et
pour diagnostiquer toute anomalie de chacune de la première aux $m^{èmes}$ batteries, ou du réseau de batteries (20), sur la base également des informations de sous-ajustage de la première aux $(m-1)^{èmes}$

9. Appareil de diagnostic de batterie (100) selon la revendication 8, le module de commande (120) étant configuré pour établir un $j^{ème}$ facteur de décalage de tension différentielle du $j^{ème}$ profil de tension différentielle de comparaison au $j^{ème}$ profil de tension différentielle de comparaison ajusté, et parmi les informations de sous-ajustage de la première aux $(m-1)^{ème}$, les $j^{ème}$ informations de sous-ajustage principales comprenant le $j^{ème}$ facteur de décalage de tension différentielle.

10. Appareil de diagnostic de batterie (100) selon la revendication 8, le module de commande (120) étant configuré pour établir un $i^{ème}$ facteur de mise à l'échelle de tension différentielle du $j^{ème}$ profil de tension différentielle de comparaison au $j^{ème}$ profil de tension différentielle de comparaison ajusté, et parmi les informations de sous-ajustage pour la première aux $(m-1)^{èmes}$, les $j^{ème}$ informations de sous-ajustage comprenant le $j^{ème}$ facteur de mise à l'échelle de tension différentielle.

11. Bloc-batterie (10) comprenant l'appareil de diagnostic de batterie (100) selon une quelconque des revendications 1 à 10.

12. Véhicule électrique comprenant le bloc-batterie (10) selon la revendication 11.

13. Procédé de diagnostic d'un réseau de batteries (20) composé de la première aux $m^{èmes}$ batteries montées en série, m étant un entier 3 ou supérieur, le procédé de diagnostic de batterie comprenant :

la collecte de données de mesure de la tension représentant la tension de chacune de la pre-

mière aux m<sup>èmes</sup> batteries lors de la charge et de la décharge du réseau de batteries (20) ;
**caractérisé par :**

la génération de profils de tension des première aux m<sup>èmes</sup> représentant un historique des variations de tension de chacune de la première aux m<sup>èmes</sup> batteries d'après des données de mesure de la tension ; et le diagnostic du réseau de batteries (20) par la comparaison de chacun des profils de tension de comparaison de la première aux (m-1)<sup>èmes</sup> avec un profil de tension critère, le profil de tension critère étant un des profils de tension pour la première aux m<sup>èmes</sup>, et les profils de tension de comparaison des première aux (m-1)<sup>èmes</sup> étant les profils de tension (m-1) restants excepté le profil de tension critère.

**14.** Procédé de diagnostic d'un réseau de batteries selon la revendication 13, l'étape de diagnostic du réseau de batterie (20) comprenant :

la génération de profils de tension de comparaison ajustés des première aux (m-1)<sup>èmes</sup> en ajustant respectivement les profils de tension de comparaison de la première aux (m-1)<sup>ème</sup>, de façon à minimiser une valeur d'erreur de chacun des profils de tension de comparaison ajustés de la première aux (m-1)<sup>èmes</sup> avec le profil de tension critère, la génération d'informations d'ajustage principales de la première aux (m-1)<sup>èmes</sup> représentant des niveaux d'ajustage des profils de tension de comparaison de la première aux (m-1)<sup>èmes</sup> à des profils de tension de comparaison ajustés pour la première aux (m-1)<sup>èmes</sup> ; et le diagnostic de toute anomalie de chacune des batteries de la première aux (m-1)<sup>èmes</sup> ou du réseau de batteries (20) d'après les informations d'ajustage principales de la première aux (m-1)<sup>èmes</sup>.

**15.** Procédé de diagnostic de batteries selon la revendication 13, comprenant en outre :

la génération d'un profil de tension différentielle critère d'après le profil de tension critère, la génération de profils de tension différentielle de comparaison de la première aux (m-1)<sup>èmes</sup> d'après les profils de tension de comparaison de la première aux (m-1)<sup>èmes</sup> ; la génération de profils de tension différentielle de comparaison ajustés de la première aux (m-1)<sup>èmes</sup> en ajustant les profils de tension différentielle de comparaison de la première aux (m-1)<sup>èmes</sup> respectivement de façon à minimiser toute valeur d'erreur de chacun des profils de tension de comparaison ajustés de la première aux (m-1)<sup>èmes</sup> avec le profil de tension différentielle critère ; et la génération d'informations de sous-ajustage de la première aux (m-1)<sup>èmes</sup> représentant des niveaux d'ajustage des profils de tension différentielle de comparaison de la première aux (m-1)<sup>èmes</sup> avec des profils de tension différentielle de comparaison ajustés de la première aux (m-1)<sup>èmes</sup>, l'étape de diagnostic du réseau de batteries (20) effectuant un diagnostic du réseau de batteries (20) basé en outre sur des informations de sous-ajustage de la première à aux (m-1)<sup>èmes</sup>.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

START

$\overparen{}$ S1710

COLLECT VOLTAGE MEASUREMENT DATA REPRESENTING VOLTAGE OF EACH OF FIRST TO $M^{TH}$ BATTERIES CONNECTED IN SERIES

$\overparen{}$ S1720

GENERATE FIRST TO $M^{TH}$ VOLTAGE PROFILES REPRESENTING VOLTAGE CHANGE HISTORY OF EACH OF FIRST TO $M^{TH}$ BATTERIES

$\overparen{}$ S1730

SET ANY ONE OF FIRST TO $M^{TH}$ VOLTAGE PROFILES AS CRITERION VOLTAGE PROFILE AND SET REMAINING (M-1) VOLTAGE PROFILES EXCLUDING CRITERION VOLTAGE PROFILE AS FIRST TO $(M-1)^{TH}$ COMPARISON VOLTAGE PROFILES

$\overparen{}$ S1740

DIAGNOSE BATTERY ARRAY BY COMPARING EACH OF FIRST TO $(M-1)^{TH}$ COMPARISON VOLTAGE PROFILES WITH CRITERION VOLTAGE PROFILE

END

FIG. 18

START

S1740

S1810

GENERATE FIRST TO $(M-1)^{TH}$ ADJUSTED COMPARISON VOLTAGE PROFILES BY ADJUSTING EACH OF FIRST TO $(M-1)^{TH}$ COMPARISON VOLTAGE PROFILES SO THAT ERROR AMOUNT WITH CRITERION VOLTAGE PROFILE IS MINIMIZED

S1820

GENERATE FIRST TO $(M-1)^{TH}$ MAIN ADJUSTMENT INFORMATION REPRESENTING ADJUSTMENT LEVEL FROM FIRST TO $(M-1)^{TH}$ COMPARISON VOLTAGE PROFILES TO FIRST TO $(M-1)^{TH}$ ADJUSTED COMPARISON VOLTAGE PROFILES

S1830

DIAGNOSE WHETHER EACH OF FIRST TO $M^{TH}$ BATTERIES OR BATTERY ARRAY IS ABNORMAL BASED ON FIRST TO $(M-1)^{TH}$ MAIN ADJUSTMENT INFORMATION

END

FIG. 19

```
                          ┌──────────┐
                          │  START   │
                          └────┬─────┘
```

⌐S1740

⌐S1910

⌐S1920

GENERATE CRITERION
DIFFERENTIAL VOLTAGE
PROFILE FROM CRITERION
VOLTAGE PROFILE

GENERATE FIRST TO (M-1)$^{TH}$
COMPARISON DIFFERENTIAL
VOLTAGE PROFILES FROM
FIRST TO (M-1)$^{TH}$ COMPARISON
VOLTAGE PROFILES

⌐S1930

GENERATE FIRST TO (M-1)$^{TH}$ ADJUSTED COMPARISON DIFFERENTIAL
VOLTAGE PROFILES BY ADJUSTING EACH OF FIRST TO (M-1)$^{TH}$
COMPARISON DIFFERENTIAL VOLTAGE PROFILES SO THAT ERROR
AMOUNT WITH CRITERION DIFFERENTIAL VOLTAGE PROFILE IS MINIMIZED

⌐S1940

GENERATE FIRST TO (M-1)$^{TH}$ SUB ADJUSTMENT INFORMATION
REPRESENTING ADJUSTMENT LEVEL FROM FIRST TO (M-1)$^{TH}$
COMPARISON DIFFERENTIAL VOLTAGE PROFILES TO FIRST TO (M-1)$^{TH}$
ADJUSTED COMPARISON DIFFERENTIAL VOLTAGE PROFILES

⌐S1950

DIAGNOSE WHETHER EACH OF FIRST TO MTH BATTERIES OR
BATTERY ARRAY IS ABNORMAL FURTHER BASED ON FIRST TO (M-1)$^{TH}$
SUB ADJUSTMENT INFORMATION

```
                          ┌──────────┐
                          │   END    │
                          └──────────┘
```

FIG. 20

```
                    ┌─────────┐
                    │  START  │
                    └────┬────┘
                         │
    ┌────────────────────┼────────────────────────┐  ┌─S1740
    │                    │                         │
    │  ┌─S2010           ▼         ┌─S2020         ▼ │
    │ ┌──────────────────────┐ ┌──────────────────────┐ │
```

S1740

S2010

┌────────────────────────────────┐
│  GENERATE CRITERION            │
│  DIFFERENTIAL CAPACITY         │
│  PROFILE FROM CRITERION        │
│  VOLTAGE PROFILE               │
└────────────────────────────────┘

S2020

┌────────────────────────────────┐
│  GENERATE FIRST TO (M-1)$^{TH}$ │
│  COMPARISON DIFFERENTIAL        │
│  CAPACITY PROFILES FROM         │
│  FIRST TO (M-1)$^{TH}$ COMPARISON│
│  VOLTAGE PROFILES              │
└────────────────────────────────┘

S2030

GENERATE FIRST TO (M-1)$^{TH}$ ADJUSTED COMPARISON DIFFERENTIAL
CAPACITY PROFILES BY ADJUSTING EACH OF FIRST TO (M-1)$^{TH}$
COMPARISON DIFFERENTIAL CAPACITY PROFILES SO THAT ERROR
AMOUNT WITH CRITERION DIFFERENTIAL CAPACITY PROFILE IS MINIMIZED

S2040

GENERATE FIRST TO (M-1)$^{TH}$ SUB ADJUSTMENT INFORMATION
REPRESENTING ADJUSTMENT LEVEL FROM FIRST TO (M-1)$^{TH}$
COMPARISON DIFFERENTIAL CAPACITY PROFILES TO FIRST TO (M-1)$^{TH}$
ADJUSTED COMPARISON DIFFERENTIAL CAPACITY PROFILES

S2050

DIAGNOSE WHETHER EACH OF FIRST TO M$^{TH}$ BATTERIES OR
BATTERY ARRAY IS ABNORMAL FURTHER BASED ON FIRST TO (M-1)$^{TH}$
SUB ADJUSTMENT INFORMATION

┌─────────┐
│   END   │
└─────────┘

**REFERENCES CITED IN THE DESCRIPTION**

**Patent documents cited in the description**

- US 20220276314 A1